(19) Europäisches Patentamt
European Patent Office
Office européen des brevets

(11) EP 2 696 385 A1

(12) # EUROPEAN PATENT APPLICATION
published in accordance with Art. 153(4) EPC

(43) Date of publication:
**12.02.2014 Bulletin 2014/07**

(21) Application number: **12767838.1**

(22) Date of filing: **28.03.2012**

(51) Int Cl.:
***H01L 51/50*** *(2006.01)* ***C09K 11/06*** *(2006.01)*
***H05B 33/12*** *(2006.01)* ***F21Y 105/00*** *(2006.01)*

(86) International application number:
**PCT/JP2012/058116**

(87) International publication number:
**WO 2012/137640 (11.10.2012 Gazette 2012/41)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **07.04.2011 JP 2011085189**

(71) Applicant: **Konica Minolta, Inc.**
**Tokyo 100-7015 (JP)**

(72) Inventors:
- **FURUKAWA, Shun**
**Hino-shi**
**Tokyo 191-8511 (JP)**
- **KUROKI, Takaaki**
**Hino-shi**
**Tokyo 191-8511 (JP)**

(74) Representative: **Green, Mark Charles**
**Urquhart-Dykes & Lord LLP**
**3rd Floor**
**33 Glasshouse Street**
**London W1B 5DG (GB)**

(54) **ORGANIC ELECTROLUMINESCENT ELEMENT AND LIGHTING DEVICE**

(57) The problem addressed by the present invention is providing a white phosphorescent light-emitting organic electroluminescent element that has a plurality of phosphorescent light-emitting dopants with different light emission wavelengths, that displays white emitted light, is highly efficient with a long life, and has superior stability of drive voltage for chromaticity and drive voltage over time. Also addressed is the problem of providing a lighting devise. This organic electroluminescent element has a pair of electrodes on a base material and two light emitting layers containing host material and phosphorescent light-emitting dopants between those electrodes and emits white light when electrified. The organic electroluminescent element is characterized by the host material contained in the two light emitting layers being different. The organic electroluminescent element in further characterized by at least one of the phosphorescent light-emitting dopants of the phosphorescent light-emitting dopants contained in the two light emitting layers being a blue phosphorescent light-emitting dopant with an ionization potential (Ip) of 5.3 eV or less, and at least one layer of the two light emitting layers containing a plurality of phosphorescent light-emitting dopants.

**FIG.2**

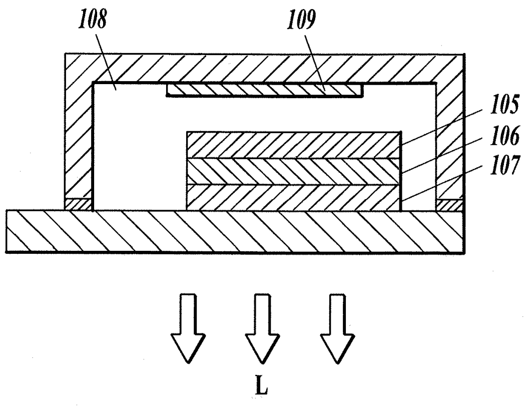


EP 2 696 385 A1

## Description

### Technical Field

The present invention relates to an organic electroluminescent element including a plurality of dopants, each of which emits phosphorescence of a different wavelength from each other, particularly emits white light, and a lighting device including the organic electroluminescent element(s).

### Background Art

As a light-emitting electronic display device, there is an electroluminescent display (hereinafter abbreviated as ELD). A constituent element of an ELD is, for example, an inorganic electroluminescent element (hereinafter also referred to as an inorganic EL element) or an organic electroluminescent element (hereinafter also referred to as an organic EL element). An inorganic electroluminescent element has been used as a flat-type light source, but high-voltage alternating current is required to drive this light-emitting element.

On the other hand, an organic electroluminescent element has a configuration that a light-emitting layer containing a light-emitting compound (s) is provided between an anode and a cathode. An organic electroluminescent element emits light through light emission (luminescence or phosphorescence) upon inactivation of excitons generated by recombining electrons and holes injected into the light-emitting layer. Further, an organic electroluminescent element can emit light with a voltage of several to several dozen volts. Still further, an organic electroluminescent element is a self-light-emitting type and thus achieves rich view angle and high visibility. In addition, because an organic electroluminescent element is a thin film type all-solid element, it is expected for its abilities to save space and to achieve portability.

In addition, an organic electroluminescent element is especially characterized by being a surface light source, different from a practically-used conventional light source such as a light-emitting diode and a cold-cathode tube. As applications effectively utilizing this characteristic, light sources for lighting and backlights of various displays are given as examples. It is also preferable to apply an organic electroluminescent element to a backlight of a liquid crystal full-colored display being in significant demand increasing especially in recent years.

When an organic electroluminescent element is used for a light source for lighting such as the above or for a backlight of a display, the organic electroluminescent element is used as a light source emitting white light or light of a so-called light bulb color (hereinafter called white light together). Method for obtaining white light emission in an organic electroluminescent element are exemplified by 1) a method for emitting white light by additive color mixture through using a plurality of light-emitting dopants of different emission wavelengths in a single element, 2) a method for obtaining white light by mixing colors through using light-emitting pixels with different colors such as blue, green and red and making the light-emitting pixels simultaneously emit light, and 3) a method for obtaining white light by using color conversion pigments.

However, judging from requirements for a light source for lighting and a backlight such as low cost, high productivity and easy driving method, a method for emitting white light by additive color mixture through using a plurality of light-emitting dopants of different emission wavelengths in a single element is effective for these use applications. Thus, research and development regarding this method have been ambitiously conducted.

Giving a detailed description of this method for emitting white light, a method for obtaining white light by mixing colors of two light-emitting dopants, the colors being complementary color, such as a blue light-emitting dopant and a yellow light-emitting dopant, and a method for obtaining white light by additive color mixture of a blue light-emitting dopant, a green light-emitting dopant and a red light-emitting dopant.

For example, a method for obtaining a white light-emitting organic electroluminescent element through doping a blue phosphorescent body, a green phosphorescent body and a red phosphorescent body, all of which are efficient, as light-emitting materials (see Patent Documents 1 and 2, for example).

In addition, in a white light-emitting organic electroluminescent element, there is a method for obtaining emission of light of a plurality of colors through using two light-emitting dopants, each of which emits light of color different from each other, in a single layer so as to efficiently transfer energy from a light-emitting dopant with high emission energy to a light-emitting dopant with relatively low emission energy, instead of using separate light-emitting layers, each of which emits light of color different from each other. This method reduces amounts of light-emitting dopants to be used, and thus is a potent method. For example, Patent Document 3 discloses an organic electroluminescent element characterized by being configured to include an anode, a red light-emitting layer and a blue light-emitting layer in sequence, the red light-emitting layer containing at least one green light-emitting dopant.

On the other hand, development of a phosphorescence-emitting dopant, which provides an organic electroluminescence element with high luminance compared to a fluorescent material, has been vigorously conducted (see Patent Document 4 and Non-Patent Documents 1 and 2, for example). Light emission from a conventional fluorescent material is emission from an excited singlet state. Because the ratio of generating singlet excitons and generating triplet

excitons is 1:3, the probability of generation of light-emitting excited species is 25%. However, in the case of a phosphorescence-emitting dopant utilizing light emission from an excited triplet state, the maximum internal quantum efficiency is 100% because of the probability of generation of light-emitting excited species and internal conversion of singlet excitons to triplet excitons. Thus, in principle, a phosphorescence-emitting dopant shows efficiency of light emission up to four times as high as that of a fluorescence-emitting dopant.

However, if a single light-emitting layer containing a phosphorescence emitting dopant(s) is used, carrier balance is adjusted only with the dopant (s) and a host material(s), and thus generation of excitons in the center area of the light-emitting layer. As a result, an area for recombination is eccentrically located, which caused energy transfer to a low-band-gap adjacent layer. Therefore, decrease of efficiency of light emission and burdens on an organic material in the adjacent layer have been concerned.

To avoid energy transfer from a light-emitting layer, a material having a band gap wider than a compound used in the light-emitting layer may be used as a carrier or exciton element layer. However, no material having a band gap wider than a blue light emission, which emits the highest energy, and has sufficient durability has been discovered.

Given the above, techniques for suppressing energy transfer to an adjacent layer and achieving high efficiency and long lifetime by stacking light-emitting layers so that light is emitted at the interface of the light-emitting layers and the area for recombination can be apart from the interface of the light-emitting layers and the adjacent layers, which achieves light emission even when excitation energy is diffused to other areas.

For example, Patent Document 5 discloses a method for improving efficiency of light emission and half-life time of luminance by stacking light-emitting layers emitting blue phosphorescence. Patent Document 6 discloses a method for improving efficiency of light emission and half-life time of luminance by stacking light-emitting layers emitting white phosphorescence. However, Patent Document 5 does not refer to white light. In addition, from the disclosure of Patent Document 5, improvements in changes in chromaticity according to driving voltage and driving time period cannot be predicted. As to Patent Document 6, this document does not define an ionization potential of a phosphorescent dopant, which is the requirement of the present invention. Thus, the adjustment of carrier balance is insufficient, and change in chromaticity is not improved. Further, this document does not describe the relationship between an ionization potential of phosphorescence-emitting material and transfer of holes nor change in chromaticity.

Prior Art Document

Patent Document

Patent Document 1: Japanese Patent Application Laid-Open Publication No. Hei6-207170
Patent Document 2: Japanese Patent Application Laid-Open Publication No. 2004-235168
Patent Document 3: International Publication WO2004/077886
Patent Document 4: U.S. Patent No. 6,097,147
Patent Document 5: Japanese Patent Application Laid-Open Publication No. 2010-34484
Patent Document 6: Japanese Patent Application Laid-Open Publication No. 2008-84913

Non-Patent Document

Non-Patent Document 1: M. A. Baldo et al., Nature, Vol. 395, pp. 151-154 (1998)
Non-Patent Document 2: M. A. Baldo et al., Nature, Vol. 403(17), pp. 750-753 (2000)

Summary of the Invention

Problem to be solved by the Invention

The present invention is made in view of the above problems. Objects of the present invention are to provide an organic electroluminescent element that emits white light including a plurality of dopants, each of which emits phosphorescence of a different wavelength from each other, and achieving high efficiency, long lifetime, excellent stability of chromaticity against change in driving voltage and excellent stability after continuous driving, and to provide a lighting device including the organic electroluminescent element(s).

Means for Solving Problem

The above object of the present invention is accomplished through configurations below.

1. An organic electroluminescent element that emits white light by energization, including:

a pair of electrodes; and
two light-emitting layers provided between the electrodes, each of the light-emitting layers including a host material and a phosphorescence-emitting dopant, wherein
the host materials included in the respective light-emitting layers are different from each other,
at least one of the phosphorescence-emitting dopants included in the respective light-emitting layers is a blue phosphorescence-emitting dopant having an ionization potential (Ip) of 5.3 eV or less, and
at least one of the two light-emitting layers includes a plurality of the phosphorescence-emitting dopants.

2. The organic electroluminescent element of the above 1, wherein

an electron affinity (Ea) of the host material included in a second light-emitting layer is larger than an electron affinity (Ea) of the host material included in a first light-emitting layer,
where a light emitting layer provided nearer to an anode is defined as the first light-emitting layer and another light-emitting layer is defined as the second light-emitting layer.

3. The organic electroluminescent element of the above 2, wherein

a lowest triplet excitation energy ($T_1$) of the host material included in the second light-emitting layer is higher than a lowest triplet excitation energy ($T_1$) of the host material included in the first light-emitting layer.

4. The organic electroluminescent element of any one of the above 1 to 3, wherein

the one or more phosphorescence-emitting dopants included in the two light-emitting layers are selected from compounds represented by the following general formulae (A), (B) and (C) :

[Chemical formula 1]

General formula (A)

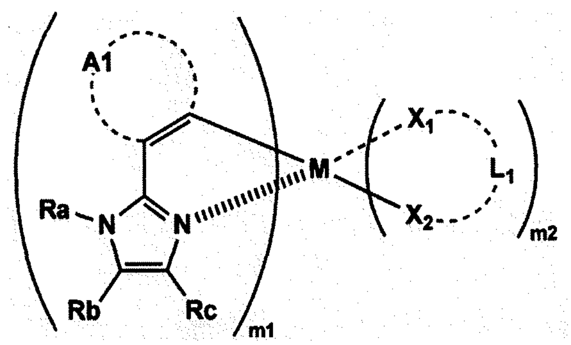

wherein in the formula, Ra represents a hydrogen atom, an aliphatic group, an aromatic group or a hetero ring; Rb and Rc each represent a hydrogen atom or a substituent; A1 represents a residue necessary for forming an aromatic ring or an aromatic hetero ring; M represents Ir or Pt; $X_1$ and $X_2$ each represent a carbon atom, a nitrogen atom or an oxygen atom; $L_1$ represents a group of atoms forming a bidentate ligand together with $X_1$ and $X_2$; m1 represents an integer 1, 2 or 3; m2 represents an integer 0, 1 or 2; and m1+m2 is 2 or 3;

[Chemical formula 2]

General formula (B)

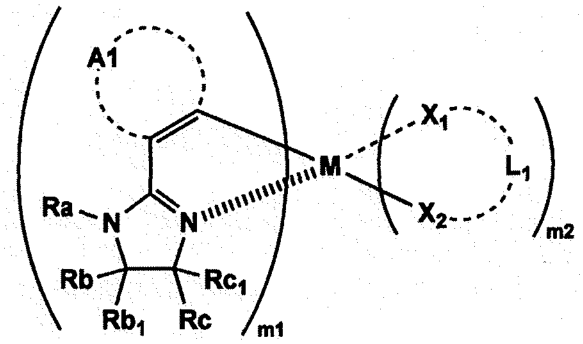

wherein in the formula, Ra represents a hydrogen atom, an aliphatic group, an aromatic group or a hetero ring; Rb, Rc, $Rb_1$ and $Rc_1$ each represent a hydrogen atom or a substituent; A1 represents a residue necessary for forming an aromatic ring or an aromatic hetero ring; M represents Ir or Pt; $X_1$ and $X_2$ each represent a carbon atom, a nitrogen atom or an oxygen atom; $L_1$ represents a group of atoms forming a bidentate ligand together with $X_1$ and $X_2$; m1 represents an integer 1, 2 or 3; m2 represents an integer 0, 1 or 2; and m1+m2 is 2 or 3; and

[Chemical formula 3]

General formula (C)

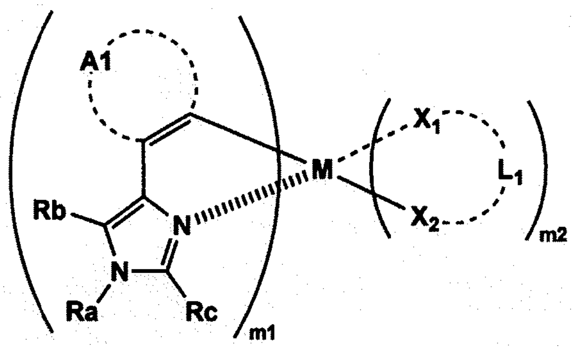

wherein in the formula, Ra represents a hydrogen atom, an aliphatic group, an aromatic group or a hetero ring; Rb and Rc each represent a hydrogen atom or a substituent; A1 represents a residue necessary for forming an aromatic ring or an aromatic hetero ring; M represents Ir or Pt; $X_1$ and $X_2$ each represent a carbon atom, a nitrogen atom or an oxygen atom; $L_1$ represents a group of atoms forming a bidentate ligand together with $X_1$ and $X_2$; m1 represents an integer 1, 2 or 3; m2 represents an integer 0, 1 or 2; and m1+m2 is 2 or 3.

5. The organic electroluminescent element of any one of the above 2 to 4, wherein

the host compound included in the first light-emitting layer and the host compound included in the second light-emitting layer include a carbazole group or carboline group.

6. The organic electroluminescent element of any one of the above 2 to 5, wherein
the first light-emitting layer and the second light-emitting layer include a same blue phosphorescence-emitting dopant.
7. The organic electroluminescent element of any one of the above 2 to 6, wherein
a total thickness of the first light-emitting layer and the second light-emitting layer ranges from 60 to 120 nm.
8. The organic electroluminescent element of any one of the above 2 to 7, wherein
the first light-emitting layer and the second light-emitting layer include (1) the dopant having a maximum emission wavelength of less than 480 nm, (2) the dopant having a maximum emission wavelength ranging from 500 nm or

more to less than 580 nm, and (3) the dopant having a maximum emission wavelength of 580 nm or more, in a light emission spectrum, respectively.

9. A lighting device including the organic electroluminescent element of any one of the above 1 to 8.

Effect of the Invention

The present invention provides a white phosphoresce-emitting organic electroluminescent element having high efficiency, long lifetime, excellent stability of chromaticity against change in driving voltage and excellent stability of chromaticity after continuous driving, and provides a lighting device including the organic electroluminescence element(s).

Brief Description of Drawings

[Fig. 1] This is a schematic diagram illustrating an example of a configuration of an organic electroluminescent element.

[Fig. 2] This is a cross sectional view illustrating an example of a configuration of an organic electroluminescent element.

Embodiments for Carrying Out the Invention

Hereinafter, details of each constituent of a white phosphorescence-emitting organic electroluminescent element (hereinafter also referred to as an organic EL element of the present invention) of the present invention will be described in sequence.

<<Chromaticity of White Light from Organic Electroluminescent Element>>

A color of light emitted from the organic EL element of the present invention or from a compound of the present invention corresponds to a color determined by applying values measured with a spectroradiometer CS-1000 (manufactured by Konica Minolta Sensing, Inc.) to the CIE chromaticity coordinate shown in Fig. 4.16 on page 108 of Handbook of Color Science, New Edition (edited by the Color Science Association of Japan, published from University of Tokyo Press, 1985).

In a correlated color temperature of 2500 to 7000 K in the CIE 1931 color space, a chromaticity of the white light-emitting organic EL element of the present invention preferably has a deviation of y value of 0.1 or less from the blackbody locus at every color temperature.

<<Layer Constitution of Organic EL Element>>

Preferable examples of the layer constitution for the present invention are shown below, but the present invention is not limited thereto.

(i) anode/first light-emitting layer/second light-emitting layer/electron-transporting layer/cathode (ii) anode/hole-transporting layer/first light-emitting layer/second light-emitting layer/electron-transporting layer/cathode

(iii) anode/hole-transporting layer/first light-emitting layer/second light-emitting layer/hole-blocking layer/electron-transporting layer/cathode

(iv) anode/hole-transporting layer/first light-emitting layer/second light-emitting layer/hole-blocking layer/electron-transporting layer/cathode buffer layer/cathode

(v) anode/anode buffer layer/hole-transporting layer/first light-emitting layer/second light-emitting layer/hole-blocking layer/electron-transporting layer/cathode buffer layer/cathode

The organic EL element of the present invention includes two light-emitting layers satisfying requirements defined in the present invention.

<<Light-Emitting Layer>>

The light-emitting layer of the present invention is a layer where electrons injected from the electrode or the electron-transporting layer and holes injected from the electrode or the hole-transporting layer are recombined to emit

light. In the present invention, a light-emitting portion is near the interface between the stacked two light-emitting layers and also apart from the interface between each the light-emitting layer and its adjacent layer. The constitution of the light-emitting layer of the present invention is not particularly limited as long as the light-emitting layer satisfies the requirements defined by the present invention.

The total thickness of the light-emitting layers is not particularly limited. In terms of uniformity of the formed light-emitting layers, prevention of application of unnecessarily high voltage for light emission and improvement stability in color of light according to driving current, the total thickness of the first light-emitting layer and the second light-emitting layer ranges preferably from 60 to 120 nm.

The light-emitting layer can be obtained by forming a film using a light-emitting dopant(s) and a host compound(s) by a known method for forming thin layers exemplified by vacuum deposition, spin coating, casting, Langmuir-Blodgett method (LB method), ink jetting, spraying, printing or slot coating.

The organic EL element of the present invention is characterized by including two light-emitting layers.

The present invention is characterized by using at least one of the phosphorescence-emitting dopants is a blue phosphorescence-emitting dopant having an ionization potential (Ip) of 5.3 eV or less.

An ionization potential of a blue phosphorescence-emitting dopant in the context of the present invention can be measured by ultraviolet photoelectron spectroscopy (UPS). In the present invention, a film composed of a single compound and having a thickness of 5 nm or more is formed on a silicon wafer on which a deposited gold film (10 nm) was provided or on indium tin oxide (abbreviated as ITO) is measured with ESCALab200R and US/1, both of which are manufactured by Vacuum Generators. Condition for the measurement is that a UV light source UPS/1 is run at 600 V and 50 mA, an excitation source is HeI (21.2 eV), a bias of -10 V is applied to the sample to be measured and the pressure is $6.7 \times 10^{-6}$ Pa. A pass energy of 2 eV is applied to the spectroscope. A spectrum width is calculated with the obtained spectrum by Tangent method, and then an Ip is obtained with the width.

In the present invention, an electron affinity (Ea) of the host material included in the second light-emitting layer is preferably larger than an electron affinity (Ea) of the host material included in the first light-emitting layer.

An electron affinity (Ea) in the context of the present invention can be obtained by, for example, subtracting a band gap energy calculated with an optical band gap from an ionization potential.

[Light-Emitting Dopant]

Next, the light-emitting dopant of the present invention will be described.

In the present invention, a phosphorescence-emitting dopant is used as the light-emitting dopant of the present invention.

(Phosphorescence-emitting dopant)

The phosphorescence-emitting dopant of the present invention (hereinafter also referred to as the "phosphorescence-emitting body") is a compound showing light emission from the level of the lowest triplet excitation energy. Specifically, the phosphorescence-emitting dopant is a compound which emits phosphorescence at room temperature (25°C) and is defined as having a phosphorescence quantum yield at 25°C of 0.01 or more, and preferably 0.1 or more.

A phosphorescence quantum yield may be measured according to the method described in page 398 of the fourth series of Experimental Chemistry 7, Spectroscopy II, 1992 from MARUZEN Co., Ltd. A phosphorescence quantum yield in a solution may be measured using various solvents as long as a phosphorescence quantum yield of phosphorescence-emitting body is 0.01 or more.

There are two principles of light emission by a phosphorescence-emitting body. One is an energy transfer-type, wherein the recombination of carriers occurs on a host compound onto which the carriers are transferred to produce an excited state of the host compound, and then via transfer of this energy to a phosphorescence-emitting compound, light emission from the phosphorescence-emitting compound occurs. The other is a carrier trap-type, wherein a phosphorescence-emitting compound serves as a carrier trap to cause recombination of carriers on the phosphorescence-emitting compound, and thereby light emission from the phosphorescence-emitting compound occurs. In each type, the energy in the excited state of the phosphorescence-emitting compound is required to be lower than that in the excited state of the host compound.

The phosphorescence-emitting body can be selected from known compounds used for a light-emitting layer of an organic EL element.

The organic EL element of the present invention is characterized in that at least one of the two light-emitting layers includes a plurality of the phosphorescence-emitting dopants.

In the organic EL element of the present invention, the first light-emitting layer and the second light-emitting layer include the same phosphorescence-emitting dopant.

The phosphorescence-emitting body of the present invention is preferably a complex containing a metal of

Groups 8 to 10 on the periodic table, more preferably an iridium compound, an osmium compound, a platinum compound (platinum complex type compound) or a rare earth complex, and most preferably an iridium compound.

Color of light from the organic EL element of the present invention is white. In addition, each of spectrum of white light emitted from the two light-emitting layers has a maximum emission wavelength within in a wavelength range of 1) less than 480 nm, and more specifically 465 nm or more to less than 480 nm, 2) 500 nm or more to less than 580 nm, or 3) 580 nm or more, and more specifically 600 nm or more to 620 nm or less. Therefore, to satisfy this requirement, the organic EL element preferably includes a blue phosphorescence-emitting dopant(s), a green phosphorescence-emitting dopant (s) and a red phosphorescence-emitting dopant(s).

(Phosphorescence-Emitting Dopant Represented By General Formula (A), (B) or (C))

In the present invention, the one or more phosphorescence-emitting dopants are preferably selected from a compound represented by the general formula (A), (B) or (C) .

In the general formula (A), Ra represents a hydrogen atom, an aliphatic group, an aromatic group or a hetero ring; Rb and Rc each represent a hydrogen atom or a substituent; A1 represents a residue necessary for forming an aromatic ring or an aromatic hetero ring; M represents Ir or Pt; $X_1$ and $X_2$ each represent a carbon atom, a nitrogen atom or an oxygen atom; $L_1$ represents a group of atoms forming a bidentate ligand together with $X_1$ and $X_2$; m1 represents an integer 1, 2 or 3; m2 represents an integer 0, 1 or 2; and m1+m2 is 2 or 3.

In the general formula (B), Ra represents a hydrogen atom, an aliphatic group, an aromatic group or a hetero ring; Rb, Rc, $Rb_1$ and $Rc_1$ each represent a hydrogen atom or a substituent; A1 represents a residue necessary for forming an aromatic ring or an aromatic hetero ring; M represents Ir or Pt; $X_1$ and $X_2$ each represent a carbon atom, a nitrogen atom or an oxygen atom; $L_1$ represents a group of atoms forming a bidentate ligand together with $X_1$ and $X_2$; m1 represents an integer 1, 2 or 3; m2 represents an integer 0, 1 or 2; and m1+m2 is 2 or 3.

Ra represents a hydrogen atom, an aliphatic group, an aromatic group or a hetero ring; Rb and Rc each represent a hydrogen atom or a substituent; A1 represents a residue necessary for forming an aromatic ring or an aromatic hetero ring; M represents Ir or Pt; $X_1$ and $X_2$ each represent a carbon atom, a nitrogen atom or an oxygen atom; $L_1$ represents a group of atoms forming a bidentate ligand together with $X_1$ and $X_2$; m1 represents an integer 1, 2 or 3; m2 represents an integer 0, 1 or 2; and m1+m2 is 2 or 3.

In the general formulae (A) to (C), Ra represents a hydrogen atom, an aliphatic group, and aromatic group or a hetero ring. Examples of the aliphatic group represented by Ra include alkyl groups (such as a methyl group, ethyl group, propyl group, butyl group, pentyl group, isopentyl group, 2-ethyl-hexyl group, octyl group, undecyl group, dodecyl group, tetradecyl group),and cycloalkyl groups (such as a cyclopentyl group and cyclohexyl group). Examples of the aromatic group include a phenyl group, tolyl group, azulenyl group, anthranyl group, phenanthryl group, pyrenyl group, chrysenyl group, naphthacenyl group, *o*-terphenyl group, *m*-terphenyl group, *p*-terphenyl group, acenaphthenyl group, coronenyl group, fluorenyl group and perylenyl group, and each of these groups may include a substituent(s). Examples of the hetero ring include a pyrrolyl group, indolyl group, furyl group, thienyl group, imidazolyl group, pyrazolyl group, indolizinyl group, quinolinyl group, carbazolyl group, indolinyl group, thiazolyl group, pyridyl group, pyridazinyl group, thiadiazinyl group, oxadiazolyl group, benzoquinolinyl group, thiadiazolyl group, pyrrolothiazolyl group, pyrrolopyridazinyl group, tetrazolyl group, oxazolyl group and chromanyl group, and each of these groups may have a substituent(s).

In the general formulae (A) to (C), examples of a substituent represented by Rb, Rc, $Rb_1$ and $Rc_1$ include alkyl groups (such as a methyl group, ethyl group, propyl group, isopropyl group, tert-butyl group, pentyl group, hexyl group, octyl group, dodecyl group, tridecyl group, tetradecyl group and pentadecyl group) ; cycloalkyl groups (such as a cyclopentyl group and cyclohexyl group); alkenyl groups (such as a vinyl group and allyl group); alkynyl groups (such as an ethynyl group and propargyl group); aryl groups (such as a phenyl group and naphthyl group) ; aromatic heterocyclic groups (such as a furyl group, thienyl group, pyridyl group, pyridazinyl group, pyrimidinyl group, pyrazinyl group, triazinyl group, imidazolyl group, pyrazolyl group, thiazolyl group, thiazolyl group, quinazolinyl group and phthalazinyl group); heterocyclic groups (such as a pyrrolidyl group, imidazolidyl group, morpholyl group and an oxazolidyl group) ; alkoxy groups (such as a methoxy group, ethoxy group, propyloxy group, pentyloxy group, hexyloxy group, octyloxy group and dodecyloxy group) ; cycloalkoxy groups (such as a cyclopentyloxy group and cyclohexyloxy group) ; aryloxy groups (such as a phenoxy group and naphthyloxy group) ; alkylthio groups (such as a methylthio group, ethylthio group, propylthio group, pentylthio group, hexylthio group, octylthio group and dodecylthio group); cycloalkylthio groups (such as a cyclopentylthio group and cyclohexylthio group); arylthio groups (such as a phenylthio group and naphthylthio group); alkoxycarbonyl groups (such as a methyloxycarbonyl group, ethyloxycarbonyl group, butyloxycarbonyl group, octyloxycarbonyl group and dodecyloxycarbonyl group); aryloxycarbonyl groups (such as a phenyloxycarbonyl group and naphthyloxycarbonyl group); sulfamoyl groups (such as an aminosulfonyl group, methylaminosulfonyl group, dimethylaminosulfonyl group, butylaminosulfonyl group, hexylaminosulfonyl group, cyclohexylaminosulfonyl group, octylaminosulfonyl group, dodecylaminosulfonyl group, phenylaminosulfonyl group, naphthylaminosulfonyl group and 2-pyridylaminosulfonyl group); acyl groups (such as an acetyl group, ethylcarbonyl group, propylcarbonyl group, pentylcarbonyl

group, cyclohexylcarbonyl group, octylcarbonyl group, 2-ethylhexylcarbonyl group, dodecylcarbonyl group, phenylcarbonyl group, naphthylcarbonyl group and pyridylcarbonyl group); acyloxy groups (such as an acetyloxy group, ethylcarbonyloxy group, butylcarbonyloxy group, octylcarbonyloxy group, dodecylcarbonyloxy group and phenylcarbonyloxy group); amido groups (such as a methylcarbonylamino group, ethylcarbonylamino group, dimethylcarbonylamino group, propylcarbonylamino group, pentylcarbonylamino group, cyclohexylcarbonylamino group, 2-ethylhexylcarbonylamino group, octylcarbonylamino group, dodecylcarbonylamino group, phenylcarbonylamino group and naphthylcarbonylamino group); carbamoyl groups (such as an aminocarbonyl group, methylaminocarbonyl group, dimethylaminocarbonyl group, propylaminocarbonyl group, pentylaminocarbonyl group, cyclohexylaminocarbonyl group, octylaminocarbonyl group, 2-ethylhexylaminocarbonyl group, dodecylaminocarbonyl group, phenylaminocarbonyl group, naphthylaminocarbonyl group and 2-pyridylaminocarbonyl group); ureido groups (such as a methylureido group, ethylureido group, pentylureido group, cyclohexylureido group, octylureido group, dodecylureido group, phenylureido group, naphthylureido group and 2-pyridylaminoureido group); sulfinyl groups (such as a methylsulfinyl group, ethylsulfinyl group, butylsulfinyl group, cyclohexylsulfinyl group, 2-ethylhexylsulfinyl group, dodecylsulfinyl group, phenylsulfinyl group, naphthylsulfinyl group and 2-pyridylsulfinyl group); alkylsulfonyl groups (such as a methylsulfonyl group, ethylsulfonyl group, butylsulfonyl group, cyclohexylsulfonyl group, 2-ethylhexylsulfonyl group and dodecylsulfonyl group); arylsulfonyl groups (such as a phenylsulfonyl group, naphthylsulfonyl group and 2-pyridylsulfonyl group); amino groups (such as an amino group, ethylamino group, dimethylamino group, butylamino group, cyclopentylamino group, 2-ethylhexylamino group, dodecylamino group, anilino group, naphthylamino group and 2-pyridylamino group); halogen atoms (such as a fluorine atom, chlorine atom and bromine atom); fluorinated hydrocarbon groups (such as a fluoromethyl group, trifluoromethyl group, pentafluoroethyl group and pentafluorophenyl group); a cyano group; a nitro group; a hydroxy group; a mercapto group; silyl groups (such as a trimethylsilyl group, triisopropylsilyl group, triphenylsilyl group and phenyldiethylsilyl group). The above substituents may be substituted with the above substituent (s) .

In the general formulae (A) to (C), A1 represents a residue necessary for forming an aromatic ring or an aromatic hetero ring. Examples of the aromatic ring include a benzene ring, biphenyl ring, naphthalene ring, azulene ring, anthracene ring, phenanthrene ring, pyrene ring, chrysene ring, naphthacene ring, triphenylene ring, *o*-terphenyl ring, *m*-terphenyl ring, *p*-terphenyl ring, acenaphthene ring, coronene ring, fluorene ring, fluoranthrene ring, naphthacene ring, pentacene ring, perylene ring, pentaphene ring, picene ring, pyrene ring, pyranthrene ring and anthranthrene ring. Examples of the aromatic hetero ring include a furan ring, thiophene ring, pyridine ring, pyridazine ring, pyrimidine ring, pyrazine ring, triazine ring, benzoimidazole ring, oxadiazole ring, triazole ring, imidazole ring, pyrazole ring, thiazole ring, indole ring, benzoimidazole ring, benzothiazole ring, benzoxazole ring, quinoxaline ring, quinazoline ring, phthalazine ring, carbazole ring, carboline ring and diazacarbazole ring (i.e., a ring where one of carbon atoms constituting the carboline ring is substituted with a nitrogen atom).

In the general formulae (A) to (C), $X_1$ and $X_2$ each represent a carbon atom, a nitrogen atom or an oxygen atom; $L_1$ represents a group of atoms forming a bidentate ligand together with $X_1$ and $X_2$. Specific examples of the bidentate ligand represented by $X_1$-L1-$X_2$ include, for example, a phenylpyridine group, a phenylpyrazole group, phenylimidazole group, phenyltriazole group, phenyltetrazole group, pyrazabole ring, picolinic acid and acetylacetone group. These groups may be non-substituted or substituted, and may be substituted with the above-described substituent(s).

In the general formulae (A) to (C), m1 represents an integer 1, 2 or 3; m2 represents an integer 0, 1 or 2; and m1+m2 is 2 or 3. Preferably, m2 is 0.

In the general formulae (A) to (C), M represents Ir or Pt. Preferably, M is Ir.

Hereinafter, specific examples of the phosphorescence-emitting dopant of the present invention represented by the general formula (A), (B) or (C). However, the present invention is not limited thereto.

[Chemical formula 4]

D-1
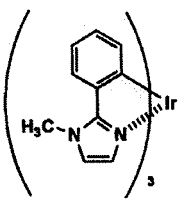
D-2
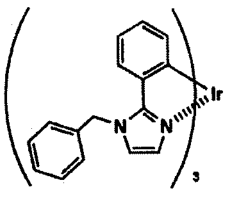
D-3
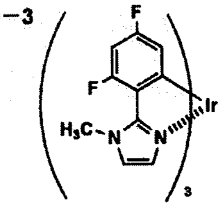

D-4
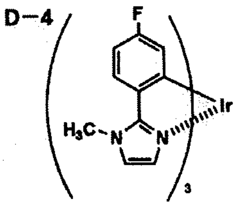
D-5
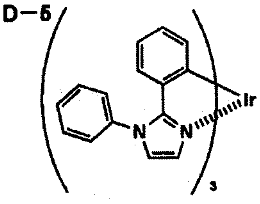
D-6
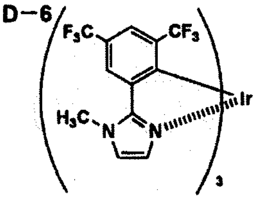

D-7
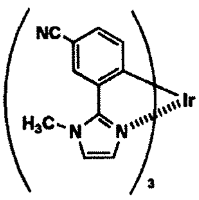
D-8
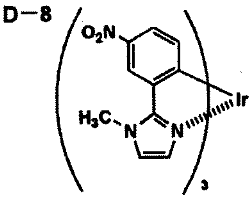
D-9
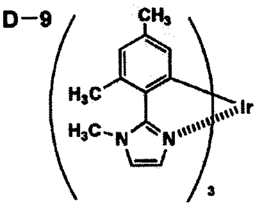

D-10
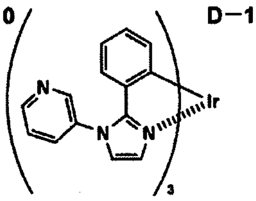
D-11
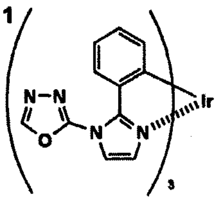
D-12
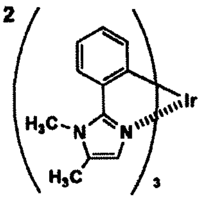

D-13
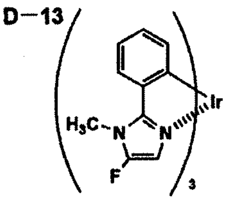
D-14
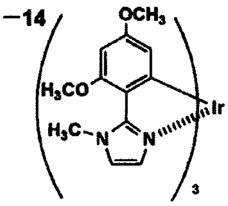
D-15
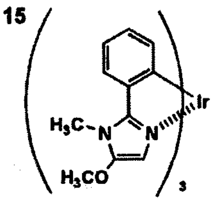

[Chemical formula 5]

D-16

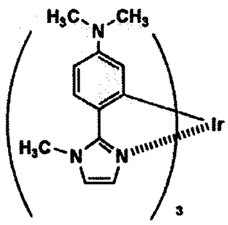

D-17

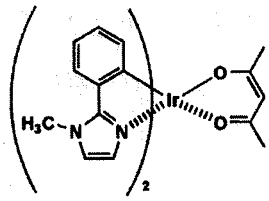

D-18

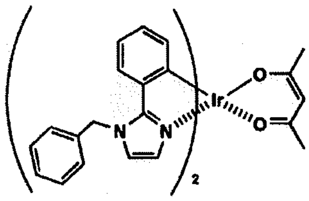

D-19

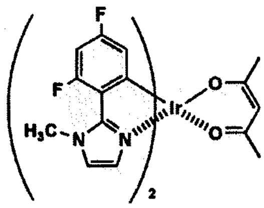

D-20

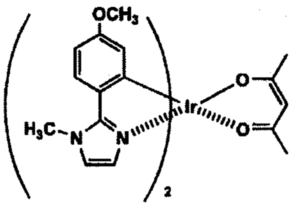

D-21

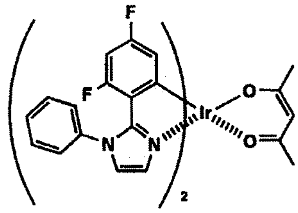

D-22

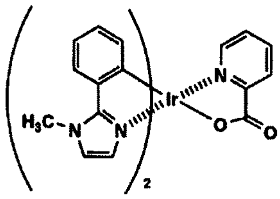

D-23

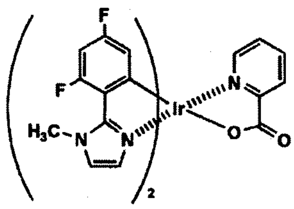

D-24

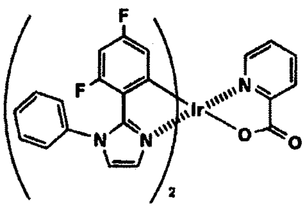

D-25

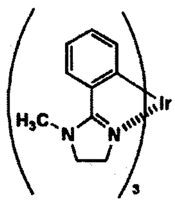

[Chemical formula 6]

D-26

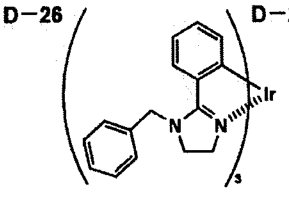

D-27

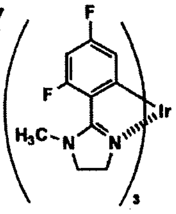

D-28

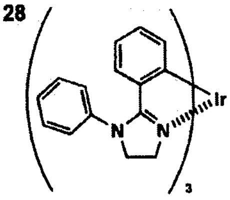

D-29

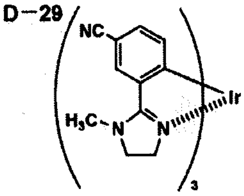

D-30

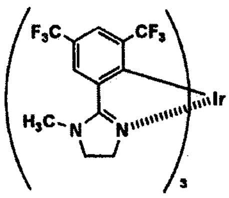

D-31

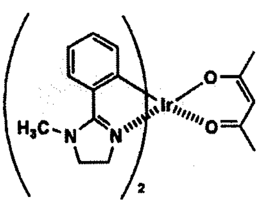

D-32

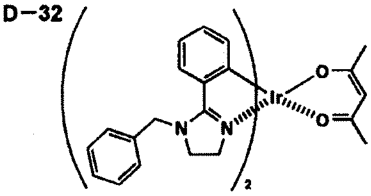

D-33

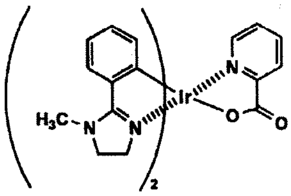

D-34

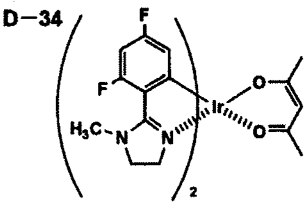

D-35

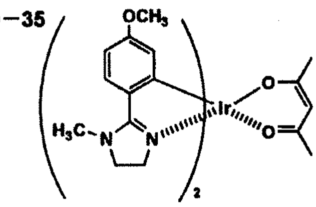

D-36

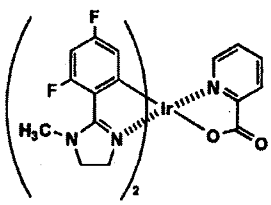

D-37

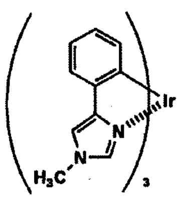

D-38

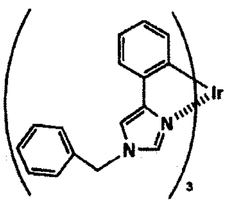

[Chemical formula 7]

D-40
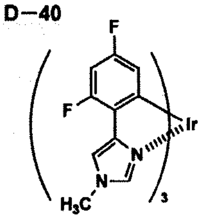
D-41
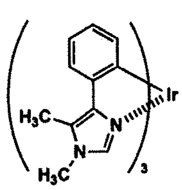
D-42
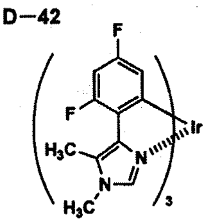

D-43
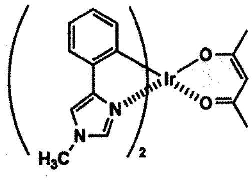
D-44
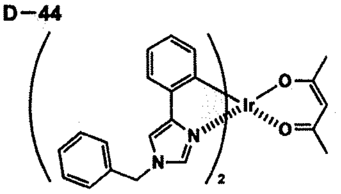

D-45
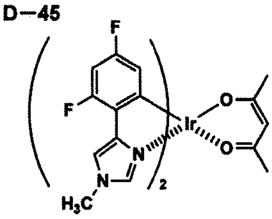
D-46
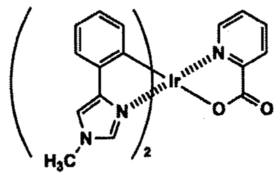

D-47
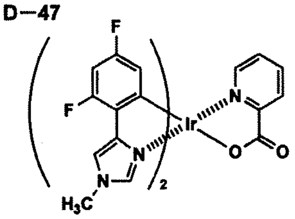
D-48
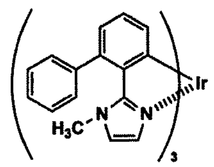

D-49
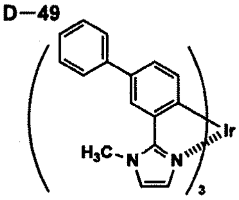
D-50
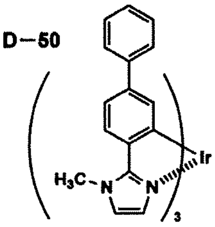
D-51
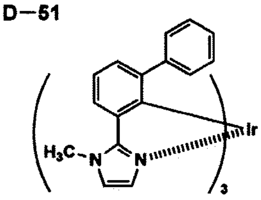

[Chemical formula 8]

D-52

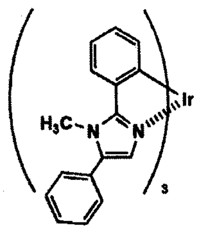

D-53

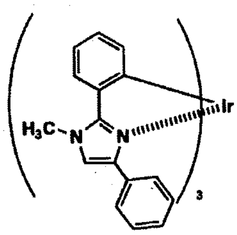

D-54

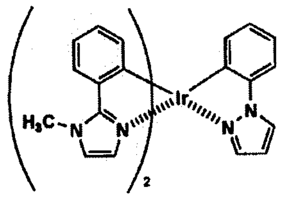

D-55

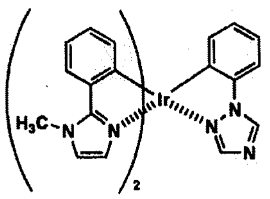

D-56

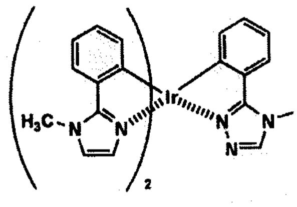

D-57

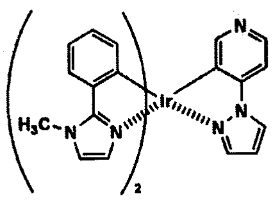

D-58

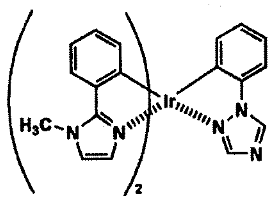

D-59

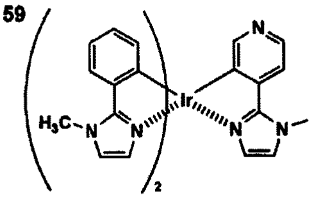

D-60

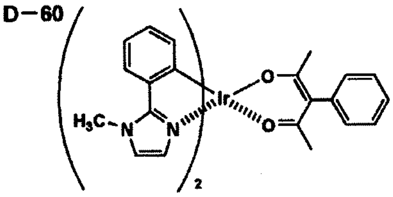

D-61

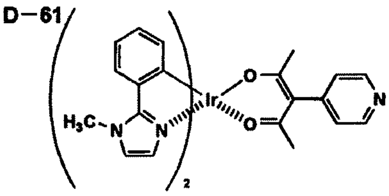

D-62

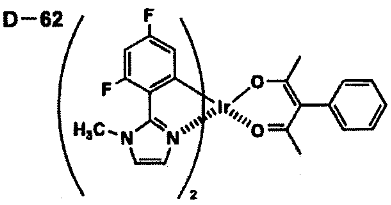

[Chemical formula 9]

D−63

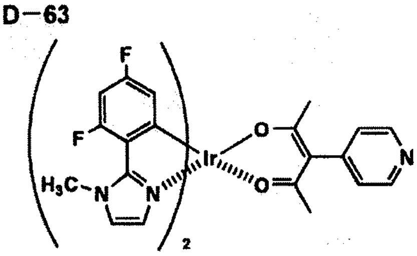

D−64

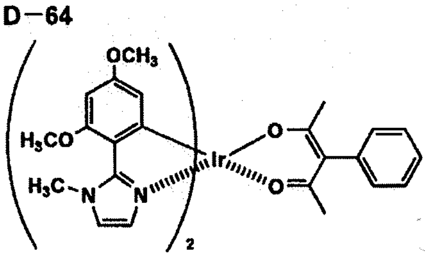

D−65

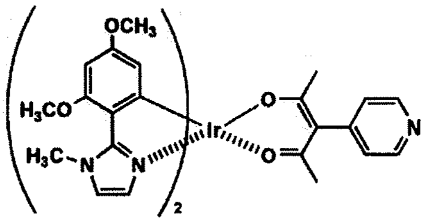

D−66

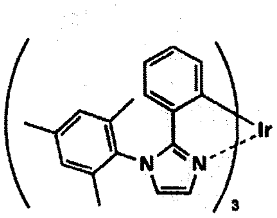

D−67

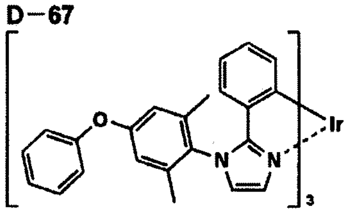

[Chemical formula 10]

D-68

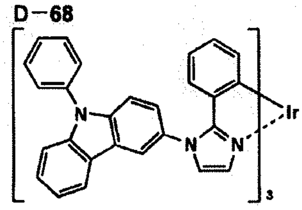

D-69

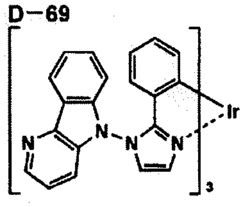

D-70

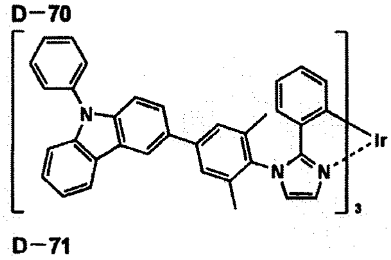

D-71

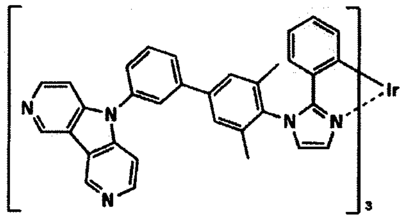

D-72

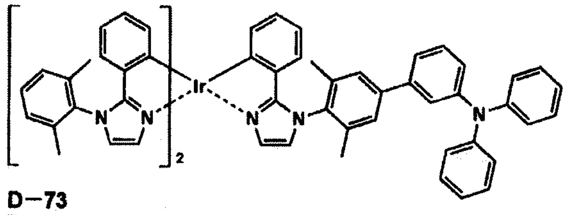

D-73

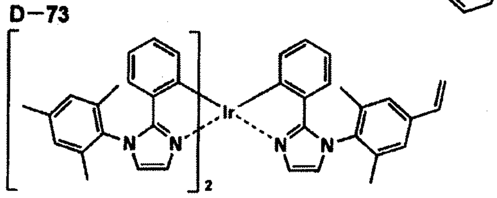

[Chemical formula 11]

D-74

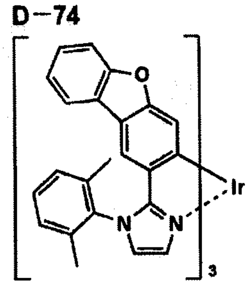

D-75

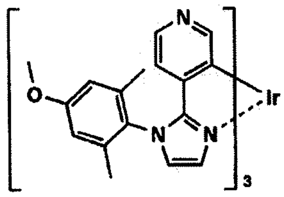

D-76

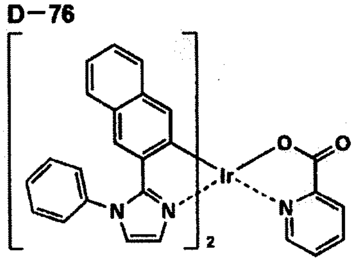

D-77

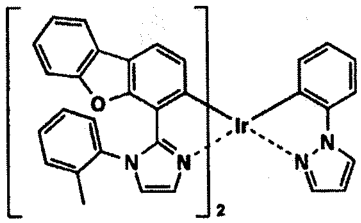

D-78

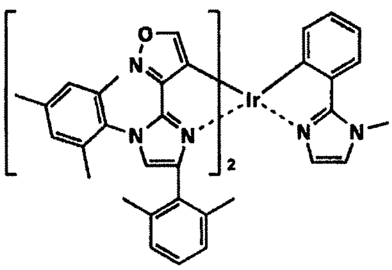

D-79

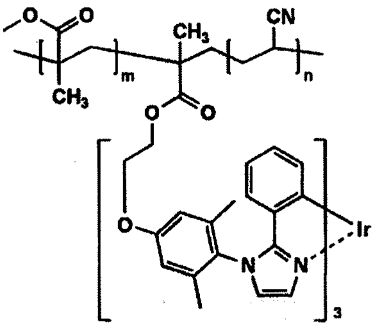

[Chemical formula 12]

D−80

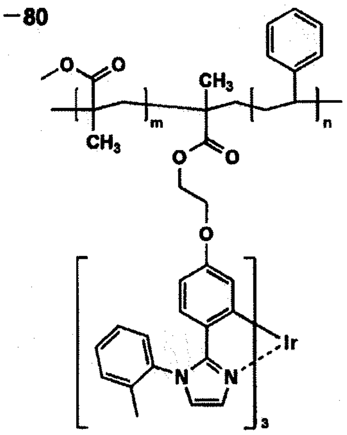

D−81

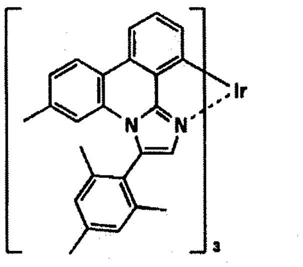

D−82

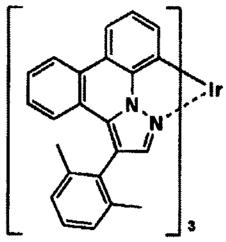

D−83

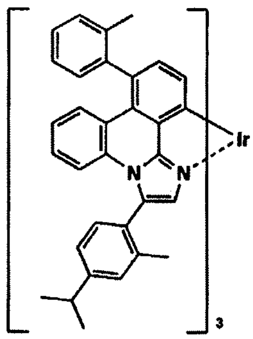

D−84

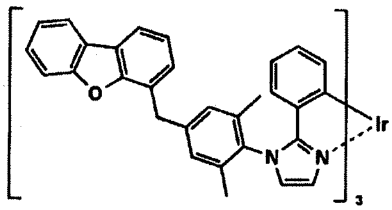

D−85

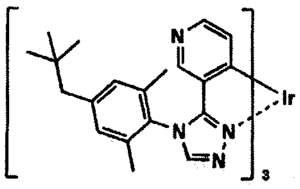

[Chemical formula 13]

D−86

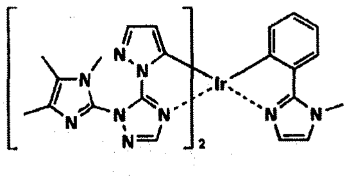

D−87

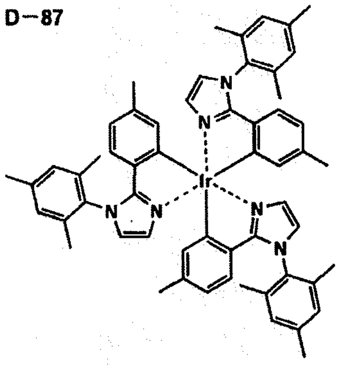

D−88

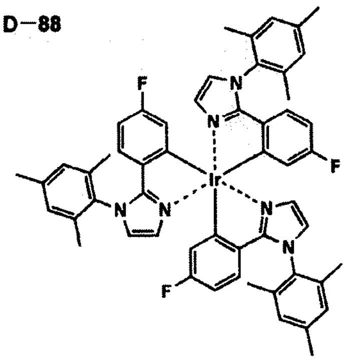

D−89

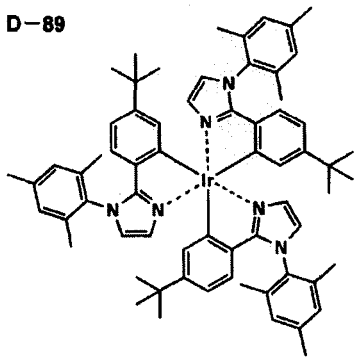

D−90

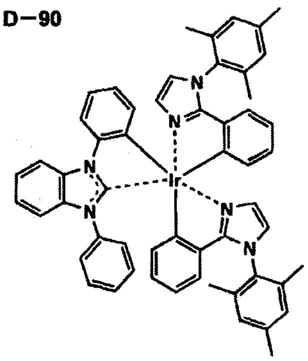

D−91

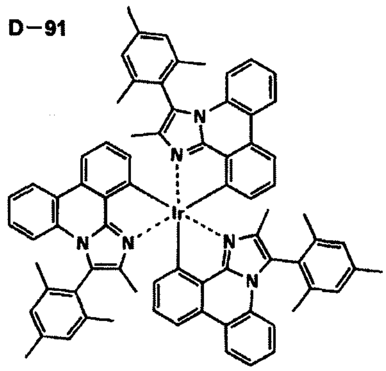

To make carrier balance in the light-emitting layers emit light near the interface between the two light-emitting layers, a compound having an ionization potential of 5.3 eV or less is used.

As the phosphorescence-emitting body, specific examples of a phosphorescence-emitting dopant other than the above phosphorescence-emitting dopant suitably used for the present invention are described below. However, the present invention is not limited thereto. Such compounds can be synthesized by a method described in Inorg. Chem. Vol. 40, pp. 1704 to 1711, for example.

[Chemical formula 14]

Ir-1

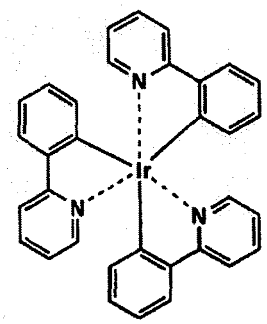

Ir-2

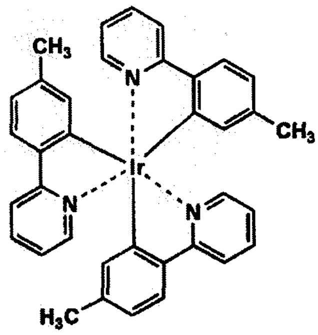

Ir-3

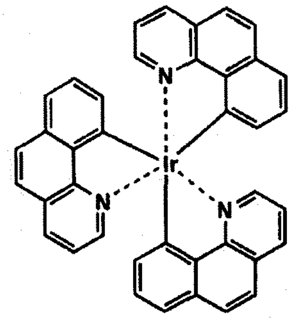

Ir-4

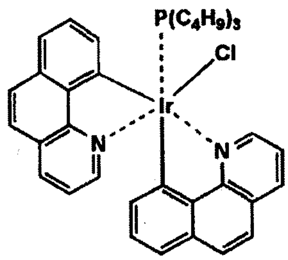

Ir-5

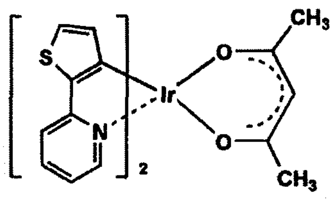

Ir-6

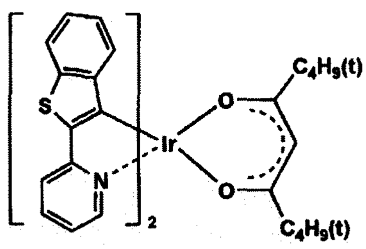

[Chemical formula 15]

Ir−7

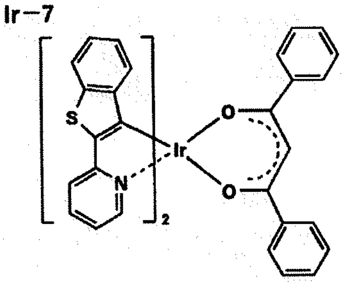

Ir−8

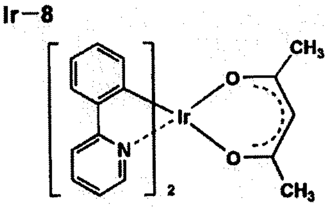

Ir−9

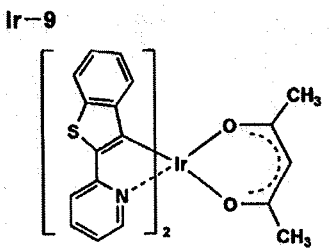

Ir−10

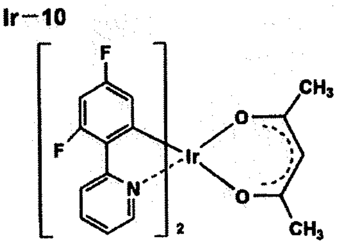

Ir−11

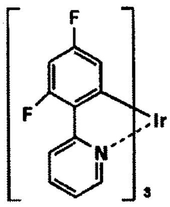

Ir−12

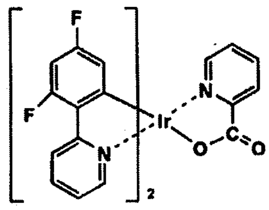

Ir−13

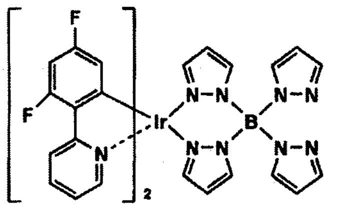

Ir−14

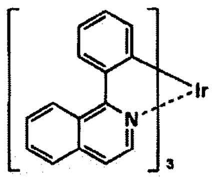

[Chemical formula 16]

Pt−1

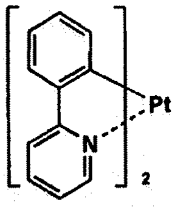

Pt−2

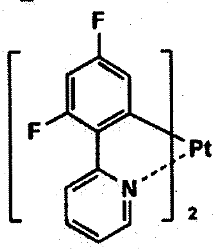

Pt−3

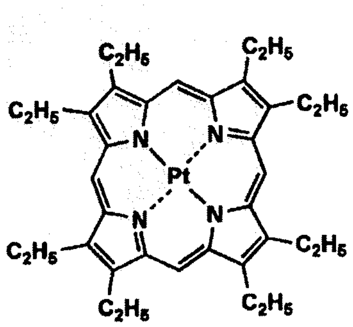

A−1

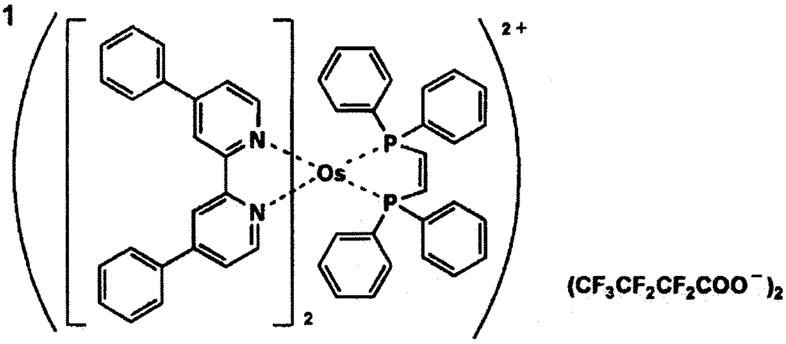

[Chemical formula 17]

d-1

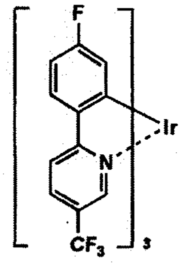

d-2

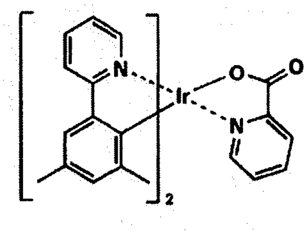

d-3

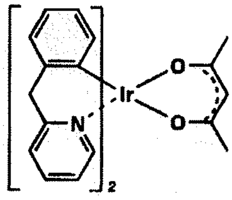

d-4

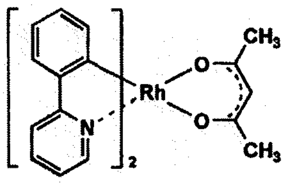

d-5

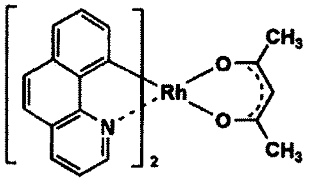

d-6

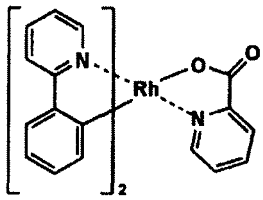

Pd-1

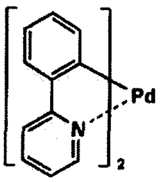

Pd-2

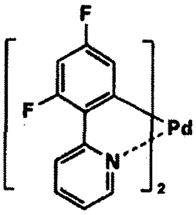

Pd-3

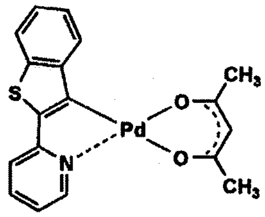

[Chemical formula 18]

Rh-1

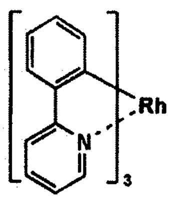

Rh-2

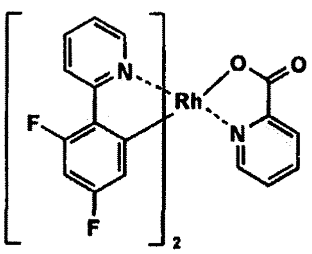

Rh-3

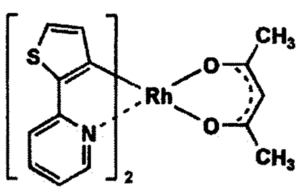

[Host Compound]

The host compound contained in the light-emitting layer will be described.

The host compound contained in the light-emitting layer of the organic EL element of the present invention is a compound having a phosphorescence quantum yield in phosphorescence emission at room temperature (25°C) of less than 0.1, and more preferably less than 0.01. The content of the host compound in the light-emitting layer is 20% by mass or more with respect to all of the compounds contained in the light-emitting layer.

For the light-emitting layer of the present invention, one or more host compounds may be used. The host materials included in the respective light-emitting layers are different from each other.

A structure of the host compound used for the present invention is not particularly limited. Representative

examples include carbazole derivatives, triarylamine derivatives, aromatic borane derivatives, nitrogen-containing hetero ring compounds, thiophene derivatives, furan derivatives, compounds including oligoarylene compounds as their basic skeletons, carboline derivatives and diazacarbazole derivatives (a diazacarbazole derivative is a compound where at least one of carbon atoms constituting hydrocarbon rings of a carboline ring of a carboline derivative is substituted with a nitrogen atom).

The host compound used for the present invention is preferably a host compound containing a carbazole group(s) or a carboline group(s).

Specific examples of the host compound employable for the present invention are described below. However, the present invention is not limited thereto.

[Chemical formula 19]

1-1

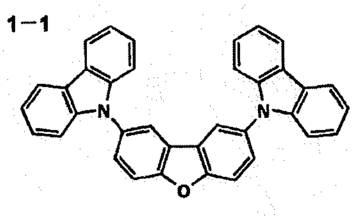

1-2

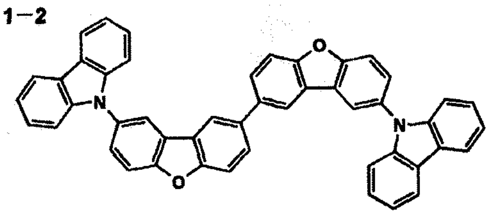

1-3

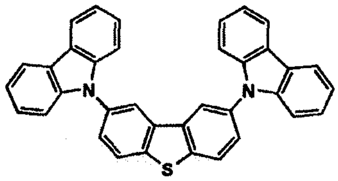

1-4

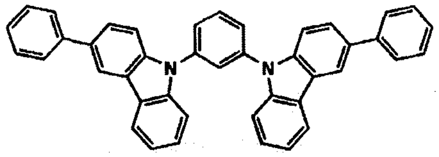

1-5

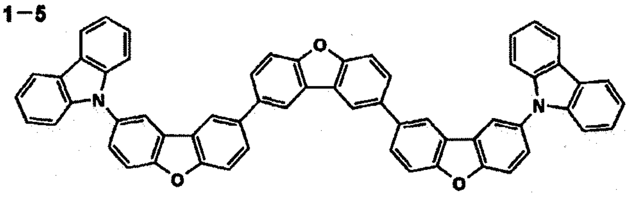

1-6

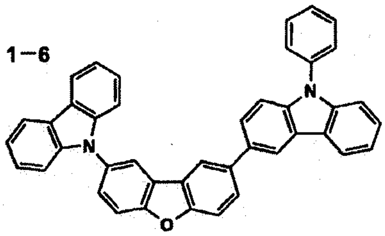

[Chemical formula 20]

1-7

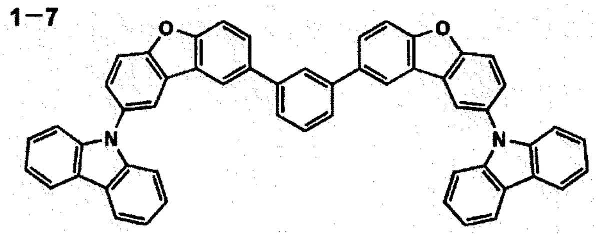

1-8

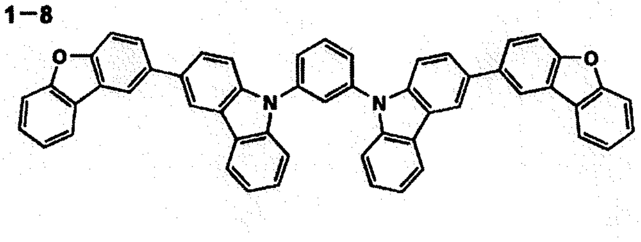

1-9

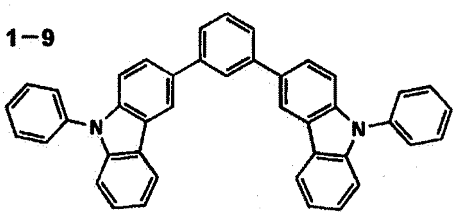

1-10

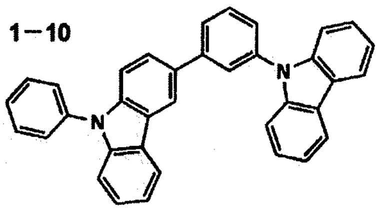

1-11

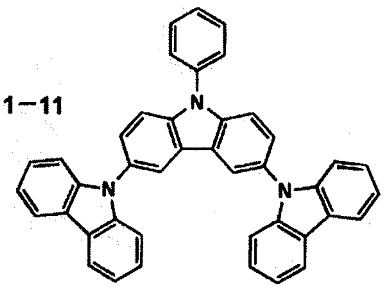

1-12

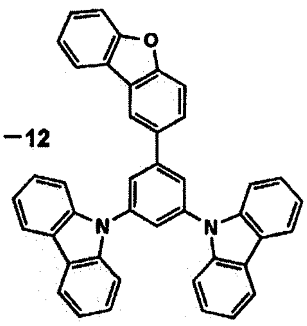

[Chemical formula 21]

1-13

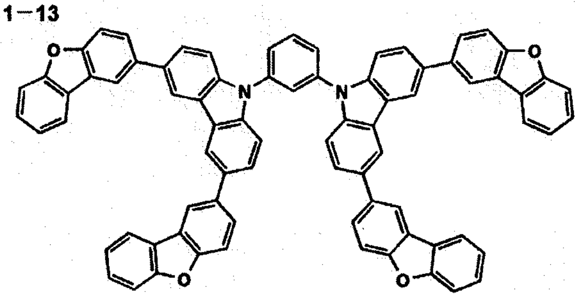

1-14

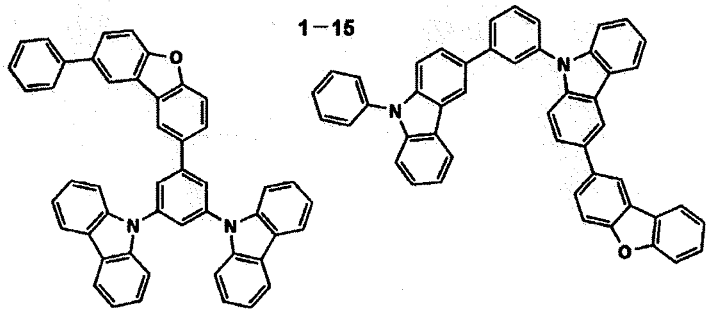

1-15

1-16

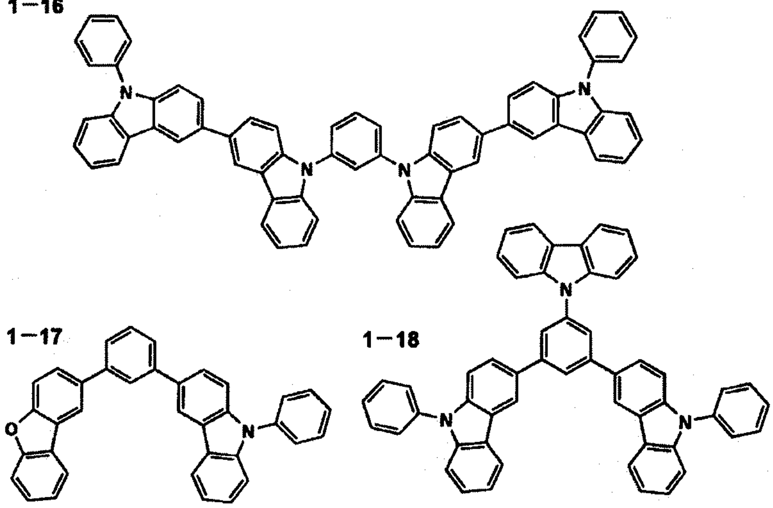

1-17

1-18

[Chemical formula 22]

1-19

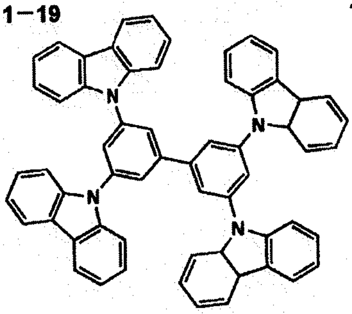

1-20

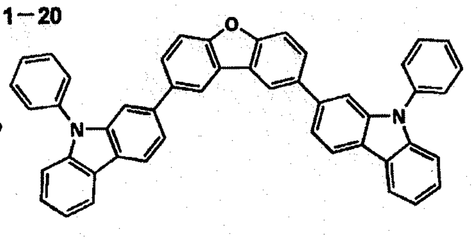

1-21

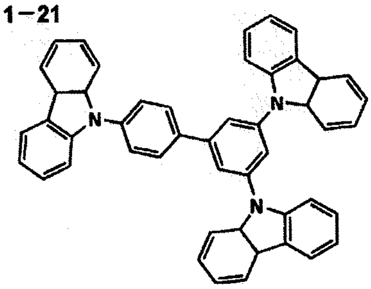

1-22

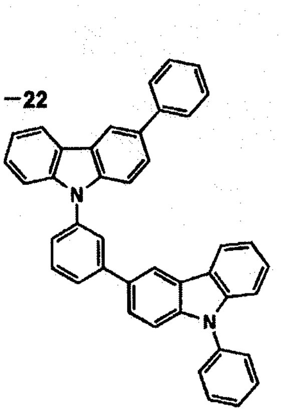

1-23

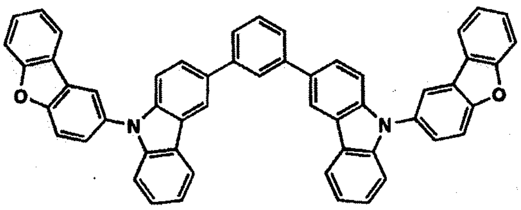

1-24

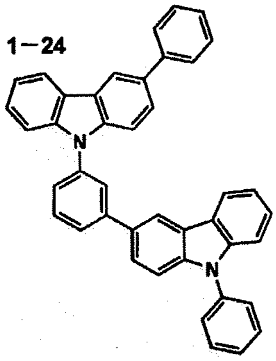

[Chemical formula 23]

1-25
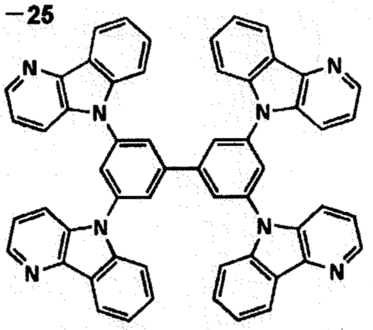

1-26
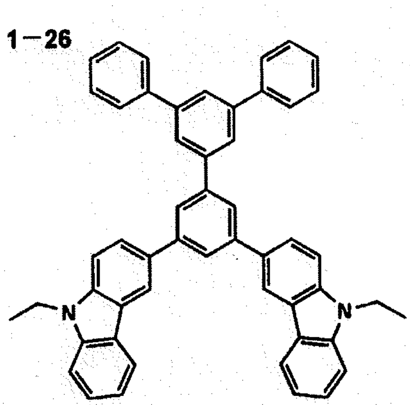

1-27
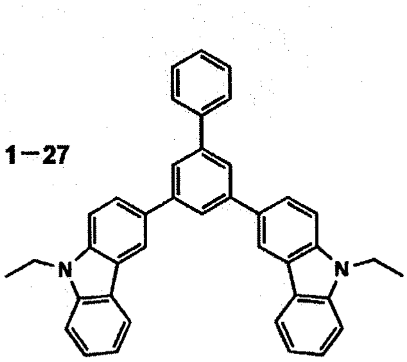

1-28
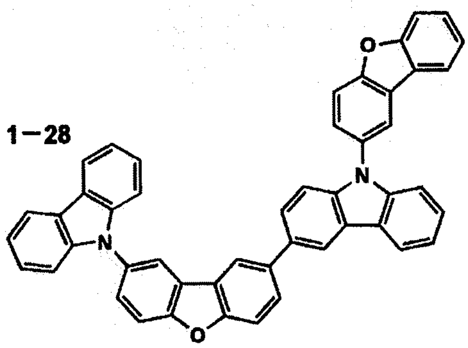

1-29
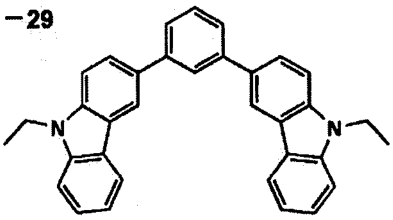

1-30
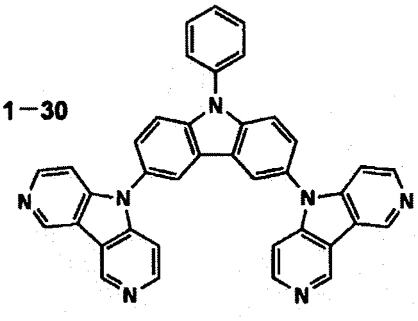

[Chemical formula 24]

1-31

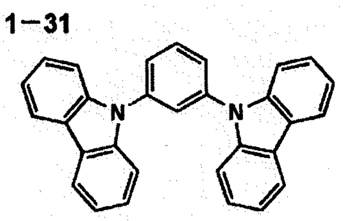

1-32

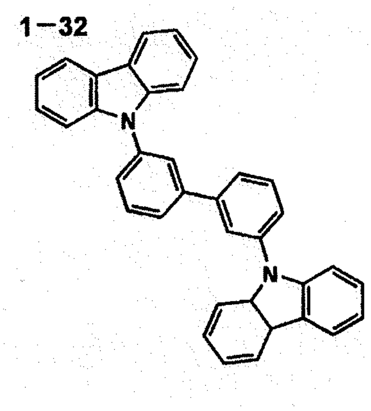

1-33

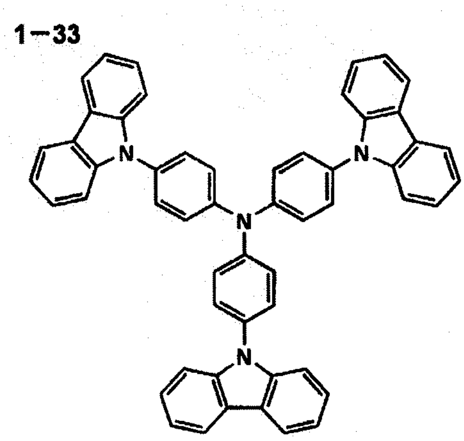

1-34

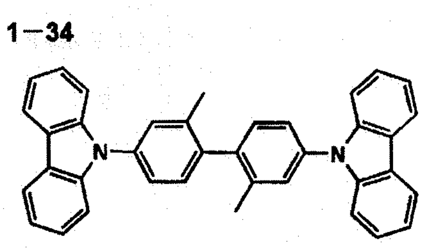

1-35

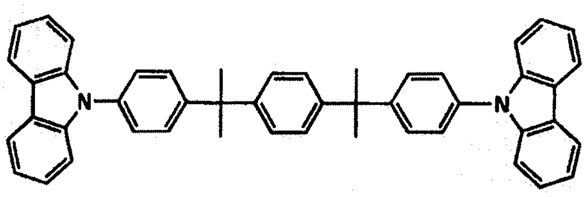

[Chemical formula 25]

1-36

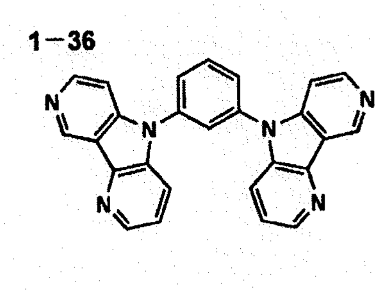

1-37

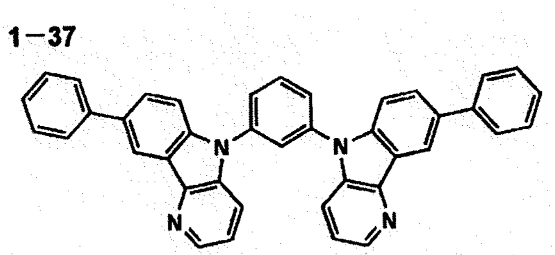

1-38

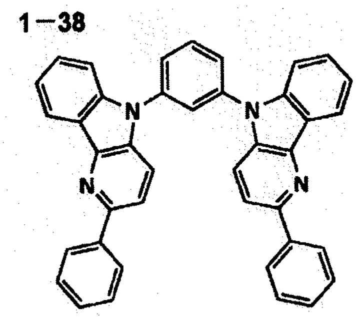

1-39

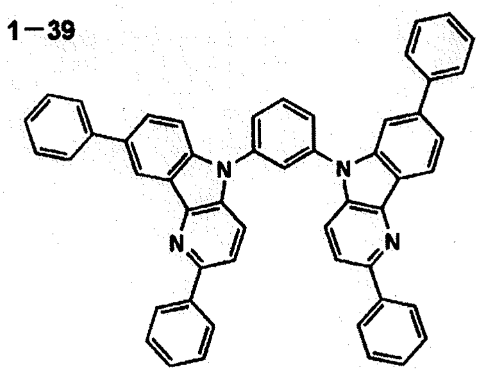

1-40

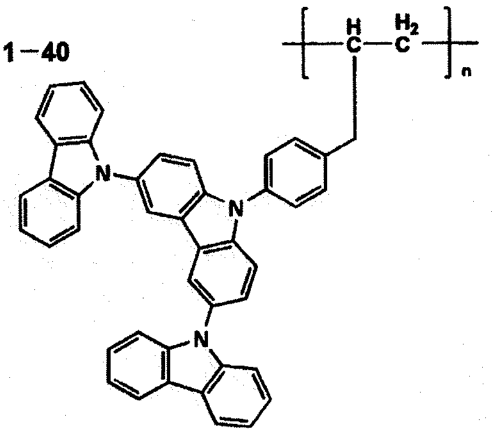

[Chemical formula 26]

1-41

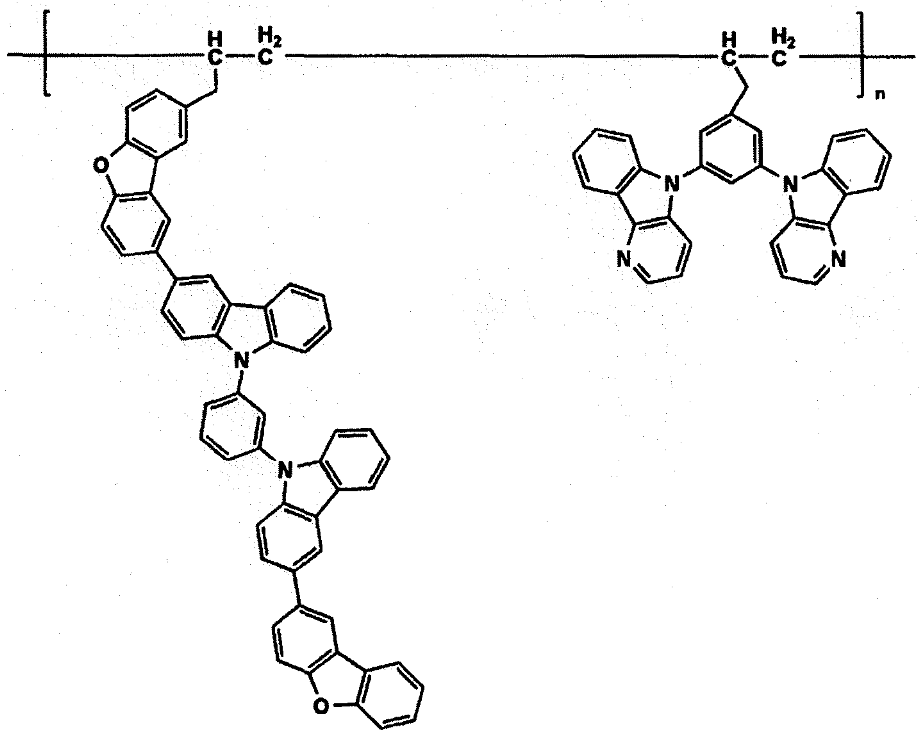

1-42

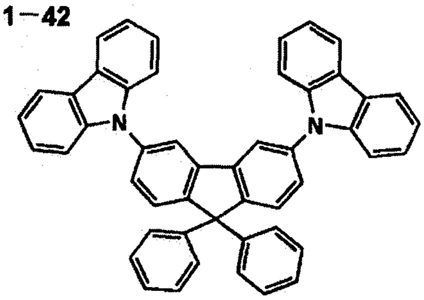

1-43

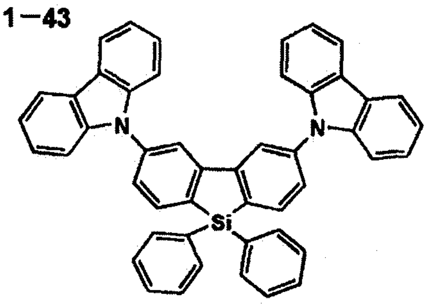

The host compound used for the present invention may be a low-molecular-weight compound, a polymer including a repeating unit(s), or a low-molecular-weight compound containing a polymerizable group(s) such as a vinyl group and epoxy group (i.e., deposition polymerizable light-emitting host).

The host compound is preferably a compound having hole-transporting properties and electron-transporting properties, avoiding lengthening of wavelength of emitted light, and having a high grass transition temperature (Tg).

Preferable examples of a conventionally known host compound other than the above include compounds described in, for example, Japanese Patent Application Laid-Open Publications Nos.2001-257076, 2002-308855, 2001-313179, 2002-319491, 2001-357977, 2002-334786, 2002-8860, 2002-334787, 2002-15871, 2002-334788, 2002-43056, 2002-334789, 2002-75645, 2002-338579, 2002-105445, 2002-343568, 2002-141173, 2002-352957, 2002-203683, 2002-363227, 2002-231453, 2003-3165, 2002-234888, 2003-27048, 2002-255934, 2002-260861, 2002-280183, 2002-299060, 2002-302516, 2002-305083, 2002-305084 and 2002-308837.

In the present invention, in the case where a plurality of the light-emitting layers are provided, the host compound(s) contained in one of the light-emitting layers may be different from the host compound (s) contained in another of the light-emitting layers. However, in terms of achieving excellent properties of lifetime for driving, it is preferable that the host compounds contained in the plurality of the light-emitting layers are the same.

In the present invention, it is preferable that a triplet excitation energy ($T_1$) of the host material included in the second light-emitting layer is higher than a triplet excitation energy ($T_1$) of the host material included in the first light-emitting layer.

In addition, to achieve higher efficiency of light emission, the host compound according to the present invention

preferably has a triplet excitation energy ($T_1$) of higher than 2.7 eV. Triplet excitation energy referred in the present invention is a peak energy of an emission band, the peak energy corresponding to the lowest transition between vibration bands obtained from the observation of a solution in which the host compound is dissolved at liquid nitrogen temperature.

In the present invention, the host compound preferably has a glass transition temperature of 90°C or more, and to achieve a longer lifetime for driving, more preferably 130°C or more.

Glass transition temperature can be obtained by Differential Scanning Colorimetry (DCS) using a method according to JIS-K-7121.

It is preferable that the host material can transport carriers, because the host material functions as a carrier transporter in the present invention. Carrier mobility is regarded as a property representing capability of carrier transportation. However, carrier mobility of an organic material generally depends on field intensity. A compound having high dependency on field intensity tends to cause an imbalance between injection of holes and electrons and transportation of holes and electrons. Thus, a material for an interlayer and the host material are preferably has mobility less dependent on field intensity.

<<Injecting Layer: Electron-Injecting Layer, Hole-Injecting Layer>>

In the organic EL element of the present invention, an injecting layer may be provided as needed. The injecting layer may be provided between the anode and the light-emitting layer or between the anode and the hole-transporting layer, or between the cathode and the light-emitting layer or between the cathode and the electron-transporting layer.

The injecting layer of the present invention is a layer provided between the electrode and the organic layer to lower driving voltage and improve luminance, and described in detail in Chapter 2 "Electrode Materials", Div. 2 Chapter 2 (pp. 123-166) of "Organic EL element and its frontier of industrialization" (published by NTS Corporation, November 30, 1998). The injecting layer is categorized into a hole-injecting layer (anode buffer layer) and electron-injecting layer (cathode buffer layer).

The anode buffer layer (hole-injecting layer) is also described in detail in Japanese Patent Application Laid-Open Publications Nos. Hei9-45479, Hei9-260062 and Hei8-288069, for example. Specific examples include a buffer layer composed of a phthalocyanine as typified by copper phthalocyanine; a buffer layer composed of an oxide as typified by vanadium oxide; a buffer layer composed of an amorphous carbon; and a buffer layer composed of an electroconductive polymer such as polyaniline (emeraldine) or polythiophene. In addition, a material(s) described in Japanese Patent Application Laid-Open Publication No. 2003-519432 are also preferably used.

The cathode buffer layer (electron-injecting layer) is also described in detail in Japanese Patent Application Laid-Open Publications Nos. Hei6-325871, Hei9-17574 and Hei10-74586, for example. Specific examples include a buffer layer composed of a metal as typified by strontium and aluminum; a buffer layer composed of an alkali metal compound as typified by lithium fluoride and potassium fluoride; a buffer layer composed of an alkali earth metal compound as typified by magnesium fluoride and cesium fluoride; a buffer layer composed of an oxide as typified by aluminum oxide.

The above buffer layers (injecting layers) are preferably very thin films. Their thicknesses are preferably from 0.1 nm to 5.0 $\mu$m, while depending on a used material(s).

<<Blocking Layer: Hole-Blocking Layer and Electron-Blocking Layer>>

The blocking layer is provided as needed in addition to fundamental constituent layers of the organic compound thin films. Examples include hole-blocking layers disclosed in Japanese Patent Application Laid-Open Publications Nos. Hei11-204258 and Hei11-204359, and page 237 of "The frontier of Organic EL element and its industrialization" (published by NTS Inc., November 30, 1998).

The hole-blocking layer functions as an electron-transporting layer in a broad sense and is composed of a hole-blocking material (s) which transports electrons while having significantly small hole-transporting properties. The hole-blocking layer transports electrons and blocks holes thereby increasing chance to recombination of electrons with holes. Constitutions of an electron-transporting layer described later may be used for the hole-blocking layer as needed.

The hole-blocking layer provided with the organic EL element of the present invention is preferably provided adjacent to the light-emitting layer.

On the other hand, the electron-blocking layer functions as a hole-transporting layer in a broad sense and is composed of a material(s) which transport holes while having significantly small electron-transporting properties. The electron-blocking layer transports holes and blocks electrons thereby increasing chance to recombination of electrons with holes. Constitutions of a hole-transporting layer described later may be used for the electron-blocking layer as needed.

The thickness of each of the hole-blocking layer and electron-transporting layer of the present invention is preferably from 3 to 100 nm, and more preferably from 5 to 30 nm.

<<Hole-Transporting Layer>>

The hole-transporting layer is composed of a hole-transporting material(s). In a broad sense, the hole-injecting layer and the electron-blocking layer are categorized into the hole-transporting layer. A single or multiple hole-transporting layers may be provided.

The hole-transporting material may be any organic or inorganic compounds having hole-injecting properties, hole-transporting properties or electron-blocking properties. Examples include triazole derivatives, oxadiazole derivatives, imidazole derivatives, polyarylalkane derivatives, pyrazoline derivatives, pyrazolone derivatives, phenylenediamine derivatives, arylamine derivatives, amino-substituted chalcone derivatives, oxazole derivatives, styrylanthracene derivatives, fluorenone derivatives, hydrazone derivatives, stilbene derivatives, silazane derivatives, aniline-based copolymers. Examples further include electroconductive polymers, particularly typified by thiophene polymers.

The above-exemplified materials may be used as the hole-transporting material. In addition, porphyrins, tertiary aromatic amines and styrylamines are preferable. Tertiary aromatic amines are particularly preferable.

Representative examples of the aromatic tertiary anime compound and stylylamine compound include N,N,N',N'-tetraphenyl-4,4'-diaminophenyl; N,N'-diphenyl-N,N'-bis(3-methylphenyl)-[1,1'-biphenyl]-4,4' -diamine (TPD); 2,2-bis(4-di-p-tolylaminophenyl)propane; 1,1-bis(4-di-p-tolylaminophenyl)cyclohexane; N,N,N',N'-tetra-p-tolyl-4,4'-diaminobiphenyl; 1,1-bis(4-di-p-tolylaminophenyl)-4-phenylcyclohexane; bis(4-dimethylamino-2-methylphenyl)phenylmethane; bis(4-di-*p*-tolylaminophenyl)phenylmethane; N,N'-diphenyl-N,N'-di(4-methoxyphenyl)-4,4'-diaminobiphenyl ; N,N,N',N'-tetraphenyl-4,4'-diaminodiphenyl ether; 4,4'-bis(diphenylamino)quaterphenyl; N,N,N-tri(*p*-tolyl)amine, 4-(di-*p*-tolylamino)-4'-[4-(di-*p*-tolylamino)styryl]stilbene; 4-N,N-diphenylamino-(2-diphenylvinyl)benzene; 3-methoxy-4'-N,N-diphenylaminostylbenzene; N-phenylcarbazole; a compound having two condensed aromatic rings in the molecule described in U.S. Patent No. 5,061,569 such as 4,4'-bis[N-(1-naphthyl)-N-phenylamino]biphenyl (NPD); and a compound described in Japanese Patent Application Laid-Open Publication No. Hei4-308688, i.e., 4,4',4''-tris[N-(3-methylphenyl)-N-phenylamino]triphenylami ne (MTDATA) in which three triphenylamine units are bonded in a starburst form.

Polymer materials where the above compound(s) are introduced in their polymer chains or are present as their main chains may also be used. Further, inorganic compounds such as p-Si and p-SiC may also be used as a hole-injecting material or hole-transporting material.

Further, a hole-transporting material having properties like those of p-type semiconductors, as described in Japanese Application Laid-Open Publications Nos. Hei4-297076, 2000-196140 and 2001-102175, J. Appl. Phys., 95, 5773 (2004), Japanese Laid-Open Application Publication No. Hei11-251067, J. Huang et al. (Applied Physics Letters 80 (2002), p. 139) and Japanese Application Laid-Open Publication No. 2003-519432, may also be used. In the present invention, these materials are preferable to obtain a light-emitting element achieving higher efficiency.

The hole-transporting layer may be obtained by forming a thin layer with the above-described hole-transporting material(s) by a known method such as vacuum deposition, spin coating, casting, ink jetting or LB method. The thickness of the hole-transporting layer is not particularly limited, but normally from about 5 nm to 5 $\mu$m, and preferably from 5 to 200 nm. The hole-transporting layer may consist of a single layer containing one or more of the above materials.

<<Electron-Transporting Layer>>

The electron-transporting layer is composed of a material (s) having electron-transporting properties, and in a broad sense, includes an electron-injecting layer and hole-blocking layer. One or more electron-transporting layers may be provided.

Heretofore, in the case of providing a single or multiple electron-transporting layers, an electron-transporting material (also used as a hole-blocking material) used in the electron-transporting layer that is adjacent to the light-emitting layer on the side of the cathode may be any material having properties for transporting electrons injected from the cathode to the light-emitting layer, and may be selected from conventionally known compounds such as nitro-substituted fuluorene derivatives, diphenylquinone derivatives, thiopyran dioxide derivatives, carbodiimides, fluorenylidene methane derivatives, derivatives of anthraquino-dimethane or anthrone, oxadiazole derivatives and the like. In addition, substituted oxadiazole derivatives where the oxygen atom on the oxadiazole ring is substituted with a sulfur atom, namely, thiadiazole derivatives and quinoxaline derivatives containing a quinoxaline ring known as an electron-withdrawing group may be used as the electron-transporting material. The above compounds may be introduced in polymer chains or used as a main chain of a polymer. Such polymers may be used as the electron-transporting material.

Further examples of the electron-transporting material include metal complexes of 8-quinolinole derivatives such as tris(8-quinolinol) aluminum (hereinafter abbreviated as Alq), tris(5,7-dichloro-8-quinolinol) aluminum, tris(5,7-dibromo-8-quinolinol) aluminum, tris(2-methyl-8-quinolinol) aluminum, tris(5-methyl-8-quinolinol)aluminum, bis(8-quinolinol) zinc (hereinafter abbreviated as Znq), and complexes where the central metal of any of these complexes is substituted with In, Mg, Cu, Ca, Sn, Ga or Pb. In addition, metal phthalocyanines, metal-free phthalocyanines, metal phthalocyanines

of which ends are substituted with an alkyl group or sulfonic acid group or metal-free phthalocyanines of which end(s) are substituted with an alkyl group or sulfonic acid group may be used as the electron-transporting material. Further, distyrylpyrazine derivatives described as examples of the material for the light-emitting layer may be used as the electron-transporting material. Inorganic semiconductors such as n-Si and n-SiC may also be used as the electron-transporting material, like the hole-injecting layer and the hole-transporting layer.

The electron-transporting layer may be obtained by forming a thin layer with the above-described electron-transporting material (s) by a known method for forming thin layers such as spin coating, casting, Langmuir Blodgett (LB) method, ink jetting, spraying, printing or a method using a slot-type coater. The thickness of the electron-transporting layer is not particularly limited, but normally from about 5 nm to 5 $\mu$m, and preferably from 5 to 200 nm. The electron-transporting layer may be a single layer composed of one or more of the above materials.

Further, an electron-transporting material doped with impurity(ies) and having high n-type properties may also be used. Examples thereof are described in Japanese Patent Application Laid-Open Publications Nos. Hei4-297076, Hei10-270172, 2000-196140 and 2001-102175, and J. Appl. Phys., 95, 5773 (2004), for example.

In the present invention, an electron-transporting material having high n-type properties is preferably used because use of this material provides an element consuming much lower power.

<<Supporting Substrate>>

The supporting substrate applied to the organic EL element of the present invention (hereinafter also referred to as substrate body, substrate, base, supporting body or the like) may be composed of, for example, glass or plastic, but types of glasses and plastics are not particularly limited. The supporting substrate may be transparent or opaque. In the case where light is extracted from the side of the supporting substrate, the supporting substrate is preferably transparent. Preferable examples of the transparent supporting substrate include a glass substrate, a quartz substrate and a transparent resin film. A particularly preferable supporting substrate is made from a resin film which is flexible and is capable of providing flexibility for an organic EL element.

Examples of the resin film include films of polyesters such as polyethylene terephthalate (PET) and polyethylene naphthalate (PEN), polyethylene, polypropylene, cellophane, cellulose esters and their derivatives such as cellulose diacetate, cellulose triacetate (TAC), cellulose acetate butylate, cellulose acetate propionate (CAP), cellulose acetate phthalate and cellulose nitrate, polyvinylidene chloride, polyvinyl alcohol, polyethylene vinyl alcohol, syndiotactic polystyrene, polycarbonate, norbornene resins, polymethylpentene, polyether ketones, polyimides, polyether sulfone (PES), polyphenylene sulfide, polysulfones, polyether imide, polyether ketone imide, polyamide, fluorine resins, nylon, polymethyl methacrylate, acrylics and polyarylates, and cycloolefin resins such as ARTON (trade name, manufactured by JSR Corp.) and APEL (trade name, manufactured by Mitsui Chemicals Inc.). On the surface of the resin film, an inorganic or organic coating film or a hybrid coating film composed of the both may be formed. The coating film is preferably a high barrier film having a moisture vapor transmission rate of 0.01 g/($m^2$·day·atm) or less determined according to JIS K 7129-1992, preferably a high barrier film having an oxygen transmission rate of $10^{-3}$ g/$m^2$/day or less determined according to JIS K 7126-1992 and a moisture vapor transmission rate of $10^{-3}$ g/$m^2$/day or less, and more preferably a high barrier film having an oxygen transmission rate of $10^{-5}$ g/$m^2$/day or less and a moisture vapor transmission rate of $10^{-5}$ g/$m^2$/day or less.

The barrier film may be formed with any material (s) that can prevent penetration of substances such as moisture and oxygen causing degradation of the element, and usable examples of the material include silicon oxide, silicon dioxide and silicon nitride. To improve weakness of the film, a barrier film having a laminate structure composed of an inorganic layer and an organic material layer is preferred. The order of these stacked inorganic layer(s) and organic layer(s) is not particularly limited, but it is preferable to stack the inorganic layers and organic layers alternately for several times.

The barrier film may be formed by any method without particular limitation. For example, vacuum deposition, sputtering, reactive sputtering, molecular beam epitaxy, ionized-cluster beam method, ion plating, plasma polymerization, atmospheric pressure plasma polymerization, plasma CVD, laser CVD, thermal CVD, or coating may be used, and atmospheric pressure plasma polymerization as described in Japanese Patent Application Laid-Open Publication No. 2004-68143 is particularly preferred.

Examples of the opaque supporting substrate include metal plates such as an aluminum plate and stainless plate, films, opaque resin substrates and ceramic substrates.

<<Sealing>>

A sealing method applicable to the organic EL element of the present invention is exemplified by a method for adhering a sealing member to electrodes and a supporting substrate with an adhesive.

It is only necessary to dispose the sealing member so as to cover a displaying area of the organic EL element (s), and the sealing member may be a concave or flat. Transparency and insulation properties are not particularly limited.

Specific examples of the sealing member include a glass plate, a composite of polymer plate and film and a composite of metal plate and film. Particular examples of a glass plate include soda-lime grass plates, barium-strontium-containing glass plates, lead glass plates, aluminosilicate glass plates, borosilicate glass plates, barium borosilicate glass plates and quartz plates. Examples of a polymer plate include polycarbonate plates, acrylic plates, polyethylene terephthalate plates, polyethersulfide plates, polysulfone plates. Examples of a metal plate include plates composed of one or more types of metals selected from stainless, iron, copper, aluminum, magnesium, nickel, zinc, chromium, titanium, molybdenum, silicon, germanium and tantalum, and plates composed of an alloy(s) of the above metals.

In the present invention, in terms of providing a thin element, polymer films and metal films are preferable. Preferable polymer films have an oxygen transmission rate of $1\times10^{-3}$ g/m$^2$/day or less and a moisture vapor transmission rate of $1\times10^{-3}$ g/m$^2$/day or less, and more preferably has an oxygen transmission rate of $10^{-5}$ g/m$^2$/day or less and a moisture vapor transmission rate of $10^{-5}$ g/m$^2$/day or less.

The sealing member may be made concave by sandblasting or chemical etching, for example. The adhesive may be exemplified by light curing or heat curing adhesives containing reactive vinyl groups of an acrylic acid-based oligomer and/or methacrylic acid-based oligomer, moisture curing adhesives such as 2-cyanoacrylate, and heat and chemical curing adhesives (mixture of two types of adhesives) such as epoxy adhesives. In addition, hot-melt polyamides, hot-melt polyesters, hot-melt polyolefins, cationic UV curing epoxy resin adhesives may also be given as examples.

To prevent the organic EL element from being deteriorated by heat, preferable adhesives are curable at a temperature ranging from room temperature up to 80°C. In the adhesive, a desiccant may be dispersed. Application of the adhesive to a sealing area may be conducted using a commercially available dispenser or conducted by printing such as screen printing.

It is also preferable to form a layer as a sealing membrane containing an inorganic or organic compound. The sealing membrane is formed on the electrode which sandwiches the organic functional layer with the supporting substrate so as to cover the electrode and the organic functional layer and so as to contact to the supporting substrate. A material used for the sealing membrane may be any materials capable of suppressing intrusion of matters that cause deterioration such as water, oxygen and the like. Examples of the material include silicon oxide, silicon dioxide, silicon nitride and the like. To improve weakness of the sealing membrane, the sealing membrane preferably has a laminated structure constituted of the inorganic layer composed of the above inorganic material (s) and an organic layer composed of an organic material(s). The sealing membrane may be formed by vacuum deposition, sputtering, reactive sputtering, molecular beam epitaxy, cluster ion beam, ion plating, plasma polymerization, atmospheric pressure plasma polymerization, plasma CVD, laser CVD, heat CVD or coating, but not specifically limited thereto.

Inert gas such as nitrogen and argon or inert liquid such as fluorohydrocarbon and silicon oil are preferably provided between the sealing member and the display area by injection to provide a gas or liquid medium between the sealing member and a display area composed of the organic EL element (s) . The gap between the sealing member and the display area may also be vacuum. Further, a hygroscopic compound may be enclosed within the gap.

The hygroscopic compound may be exemplified by metal oxides such as sodium oxide, potassium oxide, calcium oxide, barium oxide, magnesium oxide, aluminum oxide; sulfates such as sodium sulfate, calcium sulfate, magnesium sulfate, cobalt sulfate; metallic halides such as calcium chloride, magnesium chloride, cesium fluoride, tantalum fluoride, cerium bromide, magnesium bromide, barium iodide and magnesium iodide; perchloric acids such as barium perchlorate and magnesium perchlorate. As for sulfates, metallic halides and perchloric acids, anhydrous salts thereof are preferably used.

<<Protective Film, Protective Plate>>

A protective film or protective plate may be provided on the other side of the sealing membrane or sealing film, either of which is provided on the side sandwiching the organic layer with the supporting substrate, in order to improve mechanical strength of the organic EL element. It is preferable to provide the protective film or protective plate especially in the case of sealing with the sealing membrane because the sealing membrane is not so mechanically strong. Materials for the protective film or protective plate may be exemplified by a glass plate, a composite of polymer plate and film and a composite of metal plate and film, like the materials for sealing. To achieve light weight and thinness, polymer film is preferable.

<<Anode>>

For the anode of the organic EL element of the present invention, a metal, alloy, electroconductive compound or a mixture thereof, each of which has a high work function (4 eV or more), is preferably used as an electrode material. Specific examples of the electrode material include metals such as Au and transparent electroconductive materials such as CuI, indium thin oxide (ITO), $SnO_2$ and ZnO. A material that is amorphous and can be used for a transparent electroconductive film such as IDIXO ($In_2O_3$-ZnO) may also be used. The anode may be obtained by forming a thin film

with the above-described electrode material(s) by a method such as deposition or sputtering followed by patterning by photolithography to form a desired pattern. In the case where patterning does not need to be so accurate (about 100 μm or more), patterning may be conducted in deposition or sputtering of the above-described electrode material using a mask in a desired shape. In the case of using a compound that is appliable such as an organic electroconductive compound, a wet film forming method such as printing or coating may be used. For extracting emitted light from the anode, the transmittance of the anode is desirably 10% or more, and the sheet resistance of the anode is preferably a few hundreds Ω/□ or less. The thickness of the layer is usually in a range of 10 to 1000 nm, and preferably 10 to 200 nm, while depending on its material.

<<Cathode>>

On the other hand, for the cathode of the organic EL element of the present invention, a metal, alloy, electroconductive compound or a mixture thereof, each of which has a low work function (4 eV or less) (called as electron-injecting metals) is preferably used as an electrode material. Examples of such an electrode material include sodium, sodium-potassium alloy, magnesium, lithium, a mixture of magnesium and copper, a mixture of magnesium and silver, a mixture of magnesium and aluminum, a mixture of magnesium and indium, a mixture of aluminum and aluminum oxide ($Al_2O_3$), indium, a mixture of lithium and aluminum and rare earth elements. Among them, in terms of electron-injecting properties and resistance against oxidation and the like, a preferable material is a mixture of an electron-injecting metal and a secondary metal that has work function higher than that of the electron-injecting material and is stable, for example, a mixture of magnesium and silver, a mixture of magnesium and aluminum, a mixture of magnesium and indium, a mixture of aluminum and aluminum oxide ($Al_2O_3$), a mixture of lithium and aluminum, aluminum and the like. The cathode may be obtained by forming a thin layer with the above-described electrode material(s) by a method such as deposition, sputtering or the like. Sheet resistance of the cathode is preferably a few hundreds Ω/□ or less, and the thickness of the cathode is normally from 10 nm to 5 μm, and preferably from 50 to 200 nm. To transmit the emitted light, it is preferable that the anode or the cathode of the organic EL element is transparent or semi-transparent, which achieves improved luminance.

The transparent or semi-transparent cathode may be obtained by forming a layer having a thickness of 1 to 20 nm with the above-described metal and subsequently applying the transparent electroconductive material(s) described in the description of the anode 2 on the cathode; by using this procedure, an organic EL element including the anode and the cathode, both of which are transparent, are obtained.

<<Method for Manufacturing Organic EL Element>>

As an example of the method for manufacturing the organic EL element of the present invention, a method for manufacturing an organic EL element composed of anode/hole-injecting layer/hole-transporting layer/first light-emitting layer/second light-emitting layer/hole-blocking layer/electron-transporting layer /cathode will be described.

The anode is obtained by forming a thin film having a thickness of 1 μm or less, preferably 10 to 200 nm, and composed of a desired electrode material, for example, a material for the anode on a suitable base by a method for forming thin layers such as deposition or sputtering. Subsequently, the organic layers as a constituent of the organic EL element, i.e., the hole-injecting layer, the hole-transporting layer, the light-emitting layer, the electron-transporting layer and the electron-injecting layer, is formed on/over the anode.

The respective layers are formed by vapor deposition or a wet process (such as spin coating, casting, ink jetting, printing, Langmuir Blodgett (LB) method, spraying, printing, a method using a slot-type coater as described above. Preferably, vapor deposition, spin coating, ink jetting, printing or a method using a slot-type coater are preferable because these methods easily form a uniform layer and hardly generate pinholes. A method for forming each of the layer may be different from each other. In the case of using vapor deposition for forming the layer, generally, a condition for the vapor deposition is preferably that temperature is from 50 to 450°C, degree of vacuum is from $10^{-6}$ to $10^{-2}$ Pa, rate of deposition is from 0.01 to 50 nm/sec, temperature of the substrate is from -50 to 300°C, and the thickness of the layer is 0.1 nm to 5 μm, and preferably from 50 to 200 nm. After forming the above-listed layers, the cathode is obtained thereon by forming a thin film having a thickness of 1 μm or less, preferably 50 to 200 nm, and composed of a desired electrode material, for example, a material for the cathode by deposition, sputtering or the like. The organic EL element of the present invention is preferably prepared by forming the above layers from the hole-injecting layer to the cathode in a single vacuuming. However, the vacuuming may be intermitted and replaced by different methods for forming layers in midstream of the vacuuming; in this case, formation of the layers is need to be considered, for example, to be conducted under a dry inert gas atmosphere.

Alternatively, the organic EL element can also be produced in the reverse order, i.e., in order of the cathode, the electron-injecting layer, the electron-transporting layer, the hole-blocking layer, the second light-emitting layer, the first light-emitting layer, the hole-transporting layer, the hole-injecting layer and the anode. When a direct current voltage,

a voltage of about 2 to 40 V, is applied to the resulting multichromatic display device defining the anode as a positive electrode and the cathode as a negative electrode, light emission occurs. Alternatively, an alternating voltage may be applied. The alternating current to be applied may have any wave form.

In an organic EL element, it is generally understood that light emission occurs within a layer having a refractive index of around 1.6 to 2.1 which is higher than that of air, and only around 15 to 20% of the light emitted from the light-emitting layer is extracted. The reasons are that light incident on the interface (interface between a transparent substrate and the air) at θ° equal to or larger than an optimal angle is totally reflected and thus cannot be extracted to the outside of the element and that light is totally reflected between a transparent electrode or light-emitting layer and a transparent substrate, and the light is guided through the transparent electrode or light-emitting layer, resulted in light emission to the lateral sides of the element.

Examples of methods for achieving higher efficiency of light extraction include a method for preventing total reflection at the interface of the transparent substrate and air by forming irregularities on the surface of the transparent substrate (US Patent 4,774,435), a method for improving the efficiency by using a light-harvesting substrate (Japanese Patent Laid-Open Publication No. Sho63-314795), a method for forming a reflective face on lateral sides of an element (Japanese Patent Laid-Open Publication No. Hei1-220394), a method for providing, between a substrate and a light-emitting portion, a reflection-preventing layer as a smoothing layer having a refractive index intermediate in value between the substrate and the light-emitting portion (Japanese Patent Laid-Open Publication No. Sho62-172691), a method for providing a smoothing layer having a refractive index smaller than that of a substrate between the substrate and a light-emitting portion (Japanese Patent Laid-Open Publication No. 2001-202827) and a method for providing a diffracting grating at an interface between any two of a substrate, between a transparent electrode layer and light-emitting layer, or between a substrate and the outside (Japanese Patent Laid-Open Publication No. Hei11-283751).

In the present invention, the above methods may be additionally used in forming the organic EL element of the present invention. Preferable methods are the method for providing a smoothing layer having a refractive index lower than that of a substrate between the substrate and a light-emitting portion, and the method for providing a diffracting grating at the interface between any two of a substrate, between a transparent electrode layer and light-emitting layer (including the interface between a substrate and the outside).

In the present invention, combinations of the above methods achieve the element having higher luminance and higher strength.

The lower refractive index layer having a thickness longer than a light wavelength provides higher efficiency of light extraction from a transparent substrate.

The low refractive index layer may be composed of aero gel, porous silica, magnesium fluoride, fluorine-containing polymer and the like. The low refractive index of the low refractive index layer is preferably around 1.5 or less considering that a refractive index of a transparent substrate is generally from 1.5 to 1.7. More preferably, the low refractive index of the low refractive index layer 1.35 or less.

The low refractive index medium desirably has a thickness twice or more a light wavelength in the medium because if the low refractive index medium has a thickness similar to the light wavelength, the electromagnetic wave exuded as an evanescent wave penetrates into the substrate, resulting in a reduction of the effect of the low refractive index layer.

The method for providing a diffracting grating at any interface where total reflection occurs or in any layer can highly improve efficiency of light extraction. A diffraction grating functions to turn light to a specific direction other than refraction by Bragg diffraction such as a primary diffraction or secondary diffraction. This method therefore achieves extraction of the emitted light that is caught in the element due to the total reflection and the like extract light by diffraction with the diffracting grating which is provided at any interface or in any layer (for example, in a transparent substrate or transparent electrode).

The diffracting grating to be provided is preferably has two-dimensional periodic refractive index distribution. This is because light is emitted in any directions randomly in the light-emitting layer, and thus a general one-dimensional diffracting grating having a periodic refractive index in a specific direction only diffracts light in a specific direction, resulted in little improvement of efficiency of light extraction.

The diffracting grating having two-dimensional diffractive index distribution can diffract light in any directions and thus highly improve the efficiency of light extraction.

The diffracting grating may be provided at any interface or any layer (for example, in a transparent substrate or transparent electrode), and preferably provided near a light-emitting layer where light is emitted. A pitch of the diffracting grating is preferably one-second to three times of wavelength of light in the layer. The diffracting grating preferably has in a two-dimensionally repeated pattern such as square lattice, triangle lattice and honeycomb lattice.

In the organic EL element of the present invention, on a side for light extraction of the supporting substrate (the substrate), micro lens array structure may be formed or a light condensing sheet may be provided to condense light in a specific direction, for example, in a front direction with respect to a light emitting face of the element to increase luminance in a specific direction.

An exemplary structure of micro lens array is as follows: on the light extraction side of the substrate, quadrangular pyramids with a vertex angle of 90°, 30 μm on a side are two-dimensionally arranged. Each side of the quadrangular pyramids has a length of preferably from 10 to 100 μm. If each side is shorter than this range, coloring occurs; if each side is too long, the element is undesirably thick.

The light condensing sheet may be an available sheet used in an LED backlight of a liquid crystal display device, for example. Examples of such a sheet include Brightness Enhancement Film (BEF) from Sumitomo 3M Ltd, which is a prism sheet. The prism sheet may have a structure where the substrate thereof is paved with triangular prisms having a vertex angle of 90° at a pitch of 50μm between the vertexes. The vertexes of the triangular prisms may be roundish, or the pitch may be randomly varied. Other structures may also be used.

To control emission angle of light from the light-emitting element, a light diffusion plate or light diffusion film may be used in combination with the light condensing sheet. Examples include LIGHT-UP™ from KIMOTO Co. , Ltd., for example.

<<Lighting Device>>

A lighting device using the organic EL element(s) of the present invention is described.

The organic EL element of the present invention may be used in a kind of lamp such as a lighting or exposing light source, or an image projecting device or a display device for directly looking at or watching still images or videos (i.e., display). The display for reproducing videos may be driven either by a simple matrix (passive matrix) method or active matrix method.

In the white phosphorescence-emitting organic EL element in the present invention, the films are patterned with a metal mask or by ink-jet printing during formation of the films as needed. The patterning may be performed for only the electrodes or for the electrodes and the light-emitting layer or for all layers of the element. Any light-emitting dopant can be used without particular limitation for the light-emitting layer. For example, in the case of a backlight in a liquid crystal display element, white light may be made by appropriately selecting and combining the platinum complex(es) according to the present invention and/or known light-emitting dopant(s), or also using a light-extracting member or light condensing sheet in combination, so as to match with the wavelength range corresponding to color filter (CF) characteristics.

The white light-emitting organic EL element of the present invention is excellent because, by combining the elements with a color filter (CF) and arranging the elements and a driving transistor circuit(s) according to a pattern of the color filter (CF), blue light, green light and red light can be obtained through the blue filter, green filter and red filter using white light extracted from the organic EL element, and accordingly a full-colored organic electroluminescent display requiring low driving voltage and having long lifetime.

<<Industrial Field to Which Organic EL Element of the Present Invention is Applied>>

The organic EL element of the present invention may be used for display devices, displays and various light sources. Examples of light sources include various applications such as a household lighting, an in-car lighting, a backlight of a clock or liquid crystal display, a billboard, a traffic signal, a light source of an optical storage medium, a light source of an electro photocopier, a light source of an optical communication processer, a light source of an optical sensor and a general electric home appliance which requires a display device, but not limited thereto. Particularly, the organic element of the present invention may be effectively used for a backlight of a display device combined with a color filter, light-diffusing plate or light-extracting film, or a light source for lighting.

Making full use of the organic EL element of the present invention, the organic EL element of the present invention can be applied to lighting devices, light-emitting display bodies in various fields as described below.

[For Merchandise Display]

For merchandise displays, examples of application include merchandise displays in stores, refrigerator or freezer showcases, illumination of exhibits in museums, art museums or exhibition sites, vending machines, game stands and traffic advertisements.

Merchandise displays in stores include displays for decorating stores themselves, showcases, points of purchase advertising (POPs) and signs. Stores for selling luxury brand goods, jewelries or clothes and exclusive restaurants select lightings with great care because impression of stores largely depends on lightings. By using the organic EL element, indirect illumination where light sources are hidden conventionally by exercising ingenuity in building construction to make specific atmospheres does not require complex construction by virtue of saving spaces for light sources and implements. In addition, in making diffused light with interiors or signs, the organic EL element can save spaces between necessary light sources and diffusers because shapes of the light sources are not seen through the diffusers. Thus,

workability is improved. Further, as tools for changing impressions of stores, organic EL elements enables free choice of design, achieves workability and thus can be readily used because the organic EL element can conserve space by being built in display shelves, floors or store fixtures and are lightweight.

Refrigerator or freezer showcases are placed in supermarkets and convenience stores. Lightings for these showcases are important to vividly show fresh foods such as vegetables, fruits, fish and meat as goods with excellent attractiveness and freshness and to make it easy to pick these fresh foods up. By using the organic EL light sources, cooling functions are less affected because organic EL light sources emit light in low temperature. In addition, organic EL light sources are thin and thus conserve spaces for light sources, which can expand spaces for placing foods, enable slim design to make it easy to select ad pick up foods. Further, by virtue of light of color, goodness of foods can be easily recognized by consumers, which can increases sales.

In illumination of exhibits in museums, art museums or exhibition sites, it is required to select the light sources suitable for conditions of use in terms of visibility and sunburn of exhibits , and thus fluorescent lamps which avoid color deterioration and emit light having low ratio of ultraviolet light have been developed. Organic EL light sources emit light without ultraviolet light, and generate low heat generation. Thus, the organic EL light sources does not cause adverse effects to exhibits. In addition, because organic EL light sources are surface light sources evenly emitting light, organic EL light sources do not cause glare, and provide excellent color rendering, which enables appreciation of exhibits as they are. Further, the organic EL light sources do not require large implements, and thus no undesirable protrusion comes into view and viewers can concentrate solely on exhibits. In exhibition sites, because the organic EL light sources are lightweight and thin, large decorative illuminations can be constructed in relatively simple manners.

In vending machines, light sources are used for press buttons, merchandise samples and parts of posters on the front faces of vending machines. There has been competition for the spaces in the machines between implements for additional functions and goods. Thus, the organic EL light sources which are thin and conserve space can be effectively used in this field. Especially, the organic EL light sources are significantly needed for spaces for posters placed the uppers portions of the slots. Recent years, vending machines with game enjoyment such as lots (winning and missing) when selling goods have been provided. By providing light sources (video displays) with functions for controlling pixels on posters on the front faces, advantages of organic EL light sources are more effectively utilized.

Game stands include pachinko and slot-machine pachinko, for example. These game stands' primacy importance is to provide users with enjoyment of amusement (game and gamble). The organic EL light sources are thin and thus can reduce the thicknesses. Further, by providing light sources (video displays) with functions for controlling pixels on posters on the front faces, advantages of the organic EL light sources are more effectively utilized, like the case of vending machines.

Traffic advertisements include posters and signboards in public areas, posters and displays in cars such as trains and buses and advertisements on car bodies. Especially, there are box-type posters and signboards using fluorescent lightings as backlights. By replacing fluorescent lightings by the organic El light sources, these boxes can be thinner and lighter.

In the case of hanging advertisements, by thinning boxes, dust and dirt are not accumulated on these boxes and damage from bird droppings can be prevented.

[For Built-In Lighting For Interior, Furniture and Architectural Material]

In the field of architecture, lightings combined with and integrated in floors, walls, ceilings and the like are called "architectural lightings". Representative examples corning lightings, troffer lightings, cove lightings, luminous ceilings, louvered ceilings and the like, wherein these categories are determined according to their techniques. These lightings require light sources to be built in ceilings, walls or floors and thus to become unnoticed as lightings so that these lightings emit light by themselves.

Light sources using the organic EL elements are suitable for "architectural lightings" by virtue of their thinness, lightness, capability of color adjustment and changeability in design, and applicable to interiors, furnishings and store fixtures. Thus, by using the organic EL light sources, architectural lightings, which have been conventionally used only in stores and museums, can be used in public homes and thus create new demands.

In commercial facilities, the organic EL light sources can be used in half-basement stores and ceilings of arcades, and by adjusting luminance and color temperature, optimum space for commerce can be created not influenced by weather and time (day or night).

Examples of interiors, store fixtures and furnishings include desks, chairs, storage such as cupboards, shoeboxes and lockers, bathroom vanities, Buddhist alters, alters, bedlights, footlights, handrails, doors, paper doors and Fusuma doors, but not limited thereto.

Moreover, by switching light of the organic EL light sources off and making the organic EL light sources emit light, the organic EL light sources can be made transparent and opaque. By using this technique, organic EL light sources can be used for doors, blinds and partitions.

[Lighting in Car, Light-Emitting Body]

For car use, the organic EL elements can be used for external lightings and light-emitting displays, and in-car lightings and light-emitting displays. Examples of the former include front lamps (small classification), for lamps, road lights, fog lamps and winker lamps. Examples of the latter include strap lamps as rear combination lamps, road lamps, back lamps, winker lamps and number plate lamps. Especially, by using the organic EL elements to make a shingle-plate rear combination lamp and subsequently arranging the lamp on the back of a car, a space for a back lamp can be reduced and thus a space for a trunk room can be enlarged. In addition, in the case of poor visibility due to rain or fog, enlargement of the area of a road lamp and/or strap lamp can improve visibility. Meanwhile, by making a wheel emit light using organic EL elements, visibility from the lateral side can also be improved. Further, by manufacturing the whole car body with organic EL elements so that the car itself emits light, new ideas for body colors and designs can be incorporated.
Examples of the latter examples, i.e., in-car lamps and light-emitting display include in-car lamps, map lamps, lamps for getting on and off on the bottom pert of doors, meter displays, displays of car navigation systems and warning lamps. Especially, utilizing transparency of the organic EL elements, the organic EL elements can be used as sunroofs in daytime, and can be made emit light and used as in-car lamps of gentle surface light sources in night time. In a taxi, by putting a lighting device composed of the organic EL elements on the back face of the front seat, a user-friendly handy lamp system can be constructed which passengers can easily use without interfering driving by drivers and without costing the space in the taxi.

[For Public Transportation System]

In in-car lamps and displays in public transportation facilities such as trains, subways, buses, airplanes and ships, the organic EL elements can exert the advantages.
Many lighting devices are used in an airplane. Among cabin lightings, cargo room lightings and cockpit lightings, the organic EL lightings can fully exert the advantages in use as indirect cabin lightings.
As cabin lightings, fluorescent lamps and electrical lamps have been used. These lamps are not provided on the ceiling, and indirect lightings are used utilizing reflection on the lateral sides to provide a calm atmosphere for the cabin and to avoid falling of glass fragments from broken lamps caused by troubles by any possibility onto customer seats.
By using the organic EL light sources, indirect lightings can easily be produced by virtue of their thinness. In addition, in the case of use as direct lightings, the organic EL light sources are not broken, and thus there is no possibility for falling fragments. Further, a calm atmosphere can be created by diffusion lights.
For airplanes, it is important to consider power consumption and lose weight of an airframe. Thus, the organic EL light sources which are lightweight and consume less power are preferable. Such merits are effective for lighting in luggage storing spaces as well as lighting in cabin, which contributes to reduction of lost luggage.
In facilities which belong to public transportation system such as stations, bus stops and airports, displays and lightings to guide customers can be used. At outdoor bus stops in night time, bringing up the light by detecting passengers waiting for a bus can contribute crime prevention.

[Light Source for Office Automation Equipment]

Examples of office automation (OA) equipment include facsimiles, copiers, scanners, printers and combined machines thereof including scanning sensors.
Scanning sensors are categorized into contact image sensors (CIS) combined with a same-size optical system and reduction image sensor combined with an optical reduction system.
CIS is differently defined depending on manufacturers. Some manufacturers call a system where a sensor, rod lens array and LED substrate are modularized as CIS, whereas other manufacturers call a sensor chip in a module called a contact image sensor module (CISM) where a sensor, rod lens array and LED substrate are modularized as CIS. In these light sources, LED lamps, xenon lamps, CCFL lamps or LD lamps are used.
In OA equipment, downsizing and driving at lower voltage are demanded. The organic EL elements, which are thin, generate low heat generation and can be driven at low voltage, can fulfill the demand.

[Inspection System For Industry]

In manufacturers, significant man-hour and human power had been spent for visual inspection of products, and then automation of inspection with picked up images so as to determine defective products is introduced. An image of an object(s) picked up by a CCD camera is converted to digital signals, and various kinds of arithmetic processing are performed on the signals. Accordingly, area, length, number position of an object(s), for example, are extracted and

compared to set criteria, and then determined results are output. For picking up such an image, light sources are necessary. Such an inspection system is also used for inspecting packaging, shape or size and for inspecting micro products.

Light sources also used for image sensors include fluorescent lamps, LED lamps and halogen lamps, for example. Among them, backlights to illuminate transparent container or lead frames from the background are required to evenly illuminate a plane.

Meanwhile, to detect dirt on a sheet, linearly even light which can evenly illuminate the front face of the sheet in the width direction is required. Thus, different types of light sources are needed according to products to be inspected.

By using the organic EL light sources in this field, for example, in bottling process, arrangement of the lightings all around (360-degree) a bottle enables illumination and picking up of an image of the bottle at once, which shorten a time period for inspection. In addition, a space for a light source in an inspection equipment can be reduced. Because the organic EL light source is a surface light source, mistakes in inspection caused by difficulties in determination of picked up images due to light reflection can be avoided.

[Light Source For Growing Agricultural Product]

A plant factory is a "system for year-round plant production using high-tech environmental control and automation". By controlling an environment for plant growth using a computer (s), production of plants is automatically done without manpower. Considering future increase in population and environmental problems, industrialization of agriculture is needed for stable food provision by using high technologies in agriculture. In recent years, LEDs and LDs have been expected for light sources for plant growth. In lamps which are conventionally and frequently used, such as high pressure sodium lamps, spectrum balance of red light and blue light is bad. In addition, these lamps emits large amount of heat, which increases load to an air conditioner and requires a sufficient distance between these lamps and plants, resulted in big facilities.

the organic EL light sources are thin, and thus a large number of shelves can be set. In addition, heat generation of the organic EL light sources is small, and thus these light sources can be put closely to plants, which achieves high efficiency and increases amount of plants.

Further, in public homes, table gardens can be arranged in a small space in a house such as a kitchen by utilizing their space saving characteristics. Thus, concept of table gardens which have been conventionally arranged only in outdoor space such as gardens, balconies and roof terraces can be altered, and people can enjoy table gardens in various manners.

[Lighting For Evacuation]

Anti-disaster lighting facilities in accordance with Fire Defense Law, Building Standards Act and the like are categorized into guide lamps indicating exits or routes for evacuation in the case of building fires, and emergency lamps ensuring lightness of evacuation routes and speedy evacuation.

Signs, guide lamps and emergency lamps used for factory automation and the public welfare are required to be easy to see. But enlargement of them to meet the requirement cause imbalance with buildings depending on places where these lamps are arranged, resulted in discontent of architects and designers. As measures to cope with it, pictographs are introduced for signs, and light sources are used to enhance eye-catching characteristics. Conventionally, light sources of guide lamps were usually fluorescent lamps, but recently LEDs have been used for guide lamps.

By using the organic EL light sources for guide lamps, luminance spots and decrease in luminance because of angular characteristics are not caused, and visibility can be improved. The organic EL light sources consume less electricity and are thin. Thus, their setting does not need specific construction works, and exchange of lamps are less compared to conventional guide lamps using fluorescent lamps. Therefore, easy maintenance can be achieved. In addition, because heat generation is small, a light-emitting surface is less burned. Thus, guide lamps can be arranged on floors on evacuation routes, handrails of stairs, fire shutters and the like to enhance safety. Further, the organic EL light sources do not cause problems derived from mercury in currently used fluorescent lamps, and the organic EL light sources are difficult to be broken. Thus, they are excellent in safety. Still further, the organic EL light sources are thin and do not deteriorate an appearance, while achieving eye-catching characteristics.

[Lightings for Photographing]

For light sources used in photo studios, studios, ID photo booths and the like, halogen lamps, tungsten lamps, stroboscopic lamps, and fluorescent lamps are used. These light sources directly and linearly illuminate an object(s) to strongly shade the object(s), or gently illuminate with diffused light to weakly shade the object (s). These two types of light are used from various angles to be combined with each other to make a picture. To diffuse light, a diffuser is placed

between a light source and an object, or light is reflected on a plate (such as a reflector board).

The organic EL light sources emit diffused light, and thus can emit light corresponding to the latter without a diffuser. Thus, any spaces between a light source and an obj ect, which are required by conventional light sources, are not needed. In addition, shade can be controlled by bending the organic EL light sources themselves, whereas, conventionally, shade has been delicately controlled by adjusting small angles of light using a reflector board and the like.

Sometimes, light sources used in photographing require color rendering. If appearance under sunlight largely differs from that under a light source, color rendering is regarded as poor. If appearance under sunlight little differs from that under a light source, color rendering is satisfactory. Fluorescent lamps used in public homes are not suitable for photographing due to their wavelength properties, and illuminated parts tend to be greenish. Frequently, photographed skin colors, make up appearances, hairs, cloths and jewelries are desired to have the same colors as they originally have. Thus, color rendering is one of very important factors for lightings. The organic EL light sources are excellent in color rendering, and thus suitable for photographing requiring faithful reflection of colors as described above. This advantage can be utilized for evaluations in printings and staining where faithful evaluation of colors are needed.

When surface light sources such as the organic EL light sources are arranged on the entire area of the ceiling of a studio, in photographing children and/or pets, they can freely play and move in a room and can be photographed with free and natural facial expressions in natural colors without moving a light source(s) which is troublesome.

[Home Electrical Appliance]

To home electrical appliances, light sources are often used to ensure visibility of details, easiness of works and design. For example, sewing machines, kitchen microwaves, dish washer-drier, refrigerators, audio visual systems and the like conventionally include light sources. Recently, a light source (s) are set to a washer-drier because remainders increase in horizontal types. Conventional machines include light bulbs or LEDs. In future, the organic EL light sources may be used in various ways. For example, the organic EL light sources may be put on the edge of a vacuum cleaner to check the progress of cleaning in areas behind furnishings and the like, or the light sources emitting light of a specific wavelengths may be put on a shaver to check progress of shaving.

Home electrical appliances are desired to be lightweight and small-sized, and desired to have large capacities. Thus, it is desirable that a space for a light source(s) is small, and a light source(s) can illuminate the entire area. The organic EL light sources can satisfactorily fulfill the demands.

[Play Facility]

By arranging lightings using the organic EL elements under the ice of a skating rink, directions different from those in the case of illumination from above the rink using spotlights. In organic EL elements, heat generation is low, and thus organic EL elements are particularly suitable. In addition, light emission according to move of a skater(s) by detecting the skater(s) position(s) can be realized. Combination of the organic EL elements and spotlights and light emission synchronized to the rhythm of music are also effective for making the stage more exciting.

In planetariums, use of the organic EL elements can realize the dome emitting light indicating stars instead of projection from the bottom by arranging fine pixels of the organic EL elements on the whole dome. That is, use of the organic EL elements can realize a planetarium without any projection devices.

[Lighting for Illumination]

Although illumination has mainly meant tree illuminations, in recent years, in terms of environmental protection, cases where illuminations are put on houses, gates and formed objects such as fences have been widespread. In most cases, such illuminations use linearly arranged point light sources. These illuminations are expected to be further more widespread because of appearance of LEDs.

By using the organic EL lightings in this field, even in illuminating trees, lightings in a leaf shape can be put on trees, or lightings can be bent and put around trees, whereas expression has been conventionally made only with point light sources linearly linked together. In addition, fixed-formed modules can be linked together to use as a "cocktail palette" emitting light of various colors and displaying various letters and/or pictures. Such a number of variations can be realized, and thus lightings can provide greater effects.

[Lighting Attached to Belonging and Cloth]

To enhance recognition of walkers by drivers of cars or bikes in walking or running in night time, reflectors (reflection sheets, for example) which are put on a belonging (s), shoes and/or clothes to reflect light from a head lamp are available and used.

In the case of a glass beads type, fine glass beads are present on the surface and function as lens causing retro-reflection of incident light; when light from a car reaches the beads, the light then goes back and reaches the driver's eyes, and the beads appears to strongly glitter. A prism type has the same function, whereas their mechanisms are different from each other. The glass beads type has high reflection effects from diagonal directions, and the prism type reflect light from the front direction better than the glass beads type does, but reflects light from diagonal directions less than the glass beads type does. Materials and methods for adhesion of reflectors can be selected according to hardness of areas to which the reflectors are to be pasted. In these conventional types, light is required to fall on a walker to make a driver recognize the walker, and an area to which a reflector is to be pasted need to be considered, for example, a reflector is pasted on foot so as to make a driver recognize the walker as soon as possible in the case of dimmed headlamps.

By using the organic EL light sources as alternatives for them, a driver can recognize a walker before light from a headlamp reach the walker, and thus safety is ensured better than before. The organic El light sources are lighter and thinner compared to other light sources and can be a sheet, and thus the organic EL light sources can be effectively used as stickers without deteriorating merits of stickers. The organic EL light sources consume less electricity, and thus light emission by clothes with electricity generated by walking can be realized. Particularly, the organic EL light sources can be applied to clothes specifying a person to contribute early finding of a wanderer. By making a wetsuit for diving emit light, detecting a position of a diver and protecting a diver from sharks can be realized. Of course, the organic EL light sources can be used for costumes for stages such as shows or wedding dresses.

[Light Source For Communication]

Light-emitting bodies using the organic EL elements can be effectively used for "visible light tags" for sending brief messages and information using visible light. Specifically, light emission as signals by blinking at quite short intervals can send lots of information to receivers.

When a light-emitting body emits signal light, intervals of blinking of the signal light are so short that human visually recognizes that the light-emitting body is simply a lighting. Lightings set in roads, stores, exhibition facilities, hotels, amusement parks and the like can provide necessary information for receivers by sending out the information specific to places where such lightings are set. When organic EL elements are used, different types of light-emitting dopants, each of which emits light of wavelength different from each other, can be used in a single light-emitting body, and signals to be sent out can be different from each other according to wavelengths. Accordingly, a single light-emitting body can send out different items of information. In this field, organic EL elements where emission wavelength and chromaticity are stable are superior to others.

Different from providing information with sound, radio waves and infrared light, "visible light tags" can be built in lighting devices. Thus, no additional complex installation is required.

[Light Source For Medical Use]

By using the organic EL elements in endoscopes where halogen lamps are currently used or in lightings for abdominal surgery inserting wires, downsizing, weight reduction can be achieved, and thus use applications can be expanded. Especially, the organic EL elements are expected in that they can be used in endoscope capsules for internal examination or treatment (i.e., drinkable endoscopes), which have been especially attracting attention.

[Other Application]

In addition, light-emitting bodies including the organic EL elements of the present invention can select chromaticity and do not cause blinking unlike fluorescent lamps, consume less electricity and emits light with stable chromaticity, and thus can be effectively used in an insect pest controlling apparatus described in Japanese Patent Application Laid-Open Publication No. 2001-269105, a lighting for mirror described in Japanese Patent Application Laid-Open Publication No. 2001-286373, a bath room lighting system described in described in Japanese Patent Application Laid-Open Publication No. 2003-288995, an artificial light source for plant growth described in Japanese Patent Application Laid-Open Publication No. 2004-321074, an instrument for measuring water contamination described in Japanese Patent Application Laid-Open Publication No. 2004-354232, an adherend for treatment using a photosensitive drug described in Japanese Patent Application Laid-Open Publication No. 2004-358063, and a medical shadow-less lamp described in Japanese Patent Application Laid-Open Publication No. 2005-322602.

Examples

The present invention will be described in detail with reference to Examples, but is not limited thereto. Compounds used in Examples are shown below.

[Chemical formula 27]

HI-1

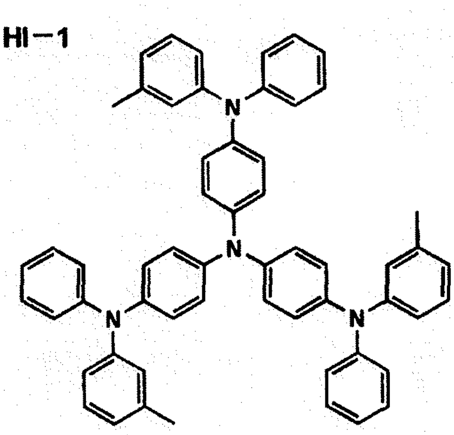

HT-1

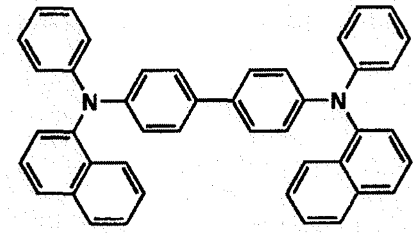

H-1

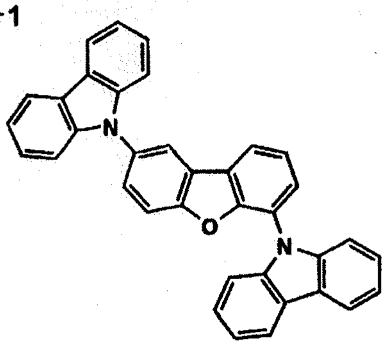

H-2

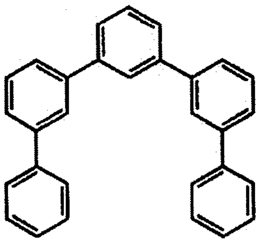

H-3

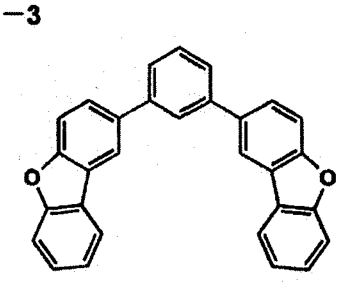

ET-1

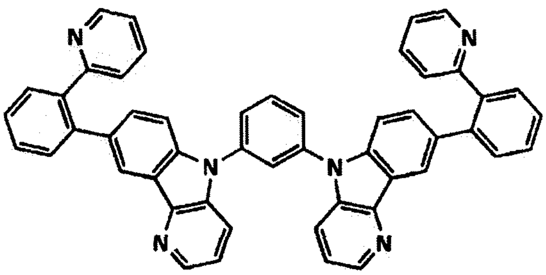

Example 1

[Preparation of Organic EL element 101]

On a 0.7 mm-thick glass substrate, a film having a thickness of 110 nm was formed with indium tin oxide (ITO) as an anode, followed by patterning. The resulting transparent substrate on which the ITO transparent electrode was subjected to ultrasonic washing with isopropyl alcohol, drying in a dry nitrogen atmosphere, and UV ozone washing for 5 minutes. Thereafter, the resulting transparent substrate was fixed on a substrate holder of a commercially-available vacuum deposition device.

Subsequently, each of the constituent materials for the layers was put in a crucible in the vacuum deposition device in an adequate amount. The used crucible was made of tungsten or molybdenum used for resistive heating.

Then the vacuum deposition device was depressurized by $1\times10^{-4}$ Pa, and the crucible in which the compound HI-1 was put was electrified to be heated so as to form a hole-injecting layer (HIL) having a thickness of 20 nm at a deposition rate of 0.1 nm/sec on the above resulting transparent substrate. Subsequently, the crucible in which the compound HT-1 was put was electrified to be heated so as to form a hole-transporting layer (HTL) having a thickness

of 20 nm at a deposition rate of 0.1 nm/sec on this resulting transparent substrate.

Thereafter, the exemplary compound D-87 which is a blue phosphorescence-emitting compound (Blue Dopant), the exemplary compound Ir-1 which is a green phosphorescence-emitting compound, the exemplary compound Ir-14 which is a red phosphorescence-emitting compound and the exemplary compound 1-6 which is the host compound were co-deposited at a deposition rate of 0.1 nm/sec so as to form a single 80 nm-thick light-emitting layer (EML) containing 20% the exemplary compound D-87, 0.3% the exemplary compound Ir-1 and 0.3% the exemplary compound Ir-14 by weight.

Subsequently, the compound ET-1 was deposited at a deposition rate of 0.1 nm/sec so as to form a 30 nm-thick electron-transporting layer, and then a 2 nm-thick film was formed with KF. Thereafter, aluminum was deposited so as to form an 110 nm-thick cathode.

Then, the above element was covered with a glass case from above the non-light-emitting face of the element. An organic EL element 101 as illustrated in Figs. 1 and 2 was thus prepared.

Fig. 1 is a schematic diagram illustrating a configuration of the organic EL element. The organic EL element 101 was covered with the glass cover 102. Sealing with the glass cover 102 was conducted in a glove box under a nitrogen atmosphere (highly pure nitrogen atmosphere with a purity of 99.999% or more) in order that the organic EL element 101 did not contact air. Fig. 2 is a cross-sectional view of the organic EL element. In Fig. 2, 105 represents the cathode, 106 represents the organic EL layers and 107 represents the glass substrate with the transparent electrode. The inner space formed by the glass cover 102 was filled with nitrogen gas 108, and a desiccant 109 was arranged in the inner space.

[Preparation of Organic EL Elements 102 to 104]

Organic EL elements 102 to 104 were prepared by the same way as the organic EL element 101 was prepared except that the exemplary compounds H-1, 1-3 and 1-7 were used as listed in Table 1, in place of the exemplary compound 1-6 as the host compounds used in the light-emitting layer.

[Preparation of Organic EL elements 105 to 111]

Organic EL elements 105 to 111 were prepared by the same way as the organic EL element 104 was prepared except that the exemplary compounds D-66, D-88, D-89, D-90, D-91, Ir-12 and Ir-13 were used as listed in Table 1, in place of the exemplary compound D-87 as the blue phosphorescence-emitting compounds used in the light-emitting layer.

[Preparation of Organic EL Element 112]

An organic EL element 112 was prepared by the same way as the organic EL element 110 was prepared except that conditions for forming the light-emitting layer were changed as described below.

<Formation of First Light-Emitting Layer and Second Light-Emitting Layer>

After forming the hole-transporting layer, the exemplary compound Ir-12 which is a blue phosphorescence-emitting compound, the exemplary compound Ir-1 which is a green phosphorescence-emitting compound, the exemplary compound Ir-14 which is a red phosphorescence-emitting compound and the exemplary compound 1-7 which is the host compound were co-deposited at a deposition rate of 0.1 nm/sec so as to form a 40 nm-thick first light-emitting layer containing 20% the exemplary compound Ir-12, 0.3% the exemplary compound Ir-1 and 0.3% the exemplary compound Ir-14 by weight. Thereafter, the exemplary compound Ir-12, the exemplary compound IR-1, the exemplary compound IR-14 and the exemplary compound 1-31 which is the host compound were co-deposited at a deposition rate of 0.1 nm/sec so as to form a 40 nm-thick second light-emitting layer containing 20% the exemplary compound Ir-12, 0.3% the exemplary compound IR-1 and 0.3% the exemplary compound IR-14 by weight. The total thickness of this two-layered light-emitting layer prepared as described above was 80 nm.

[Preparation of Organic EL Elements 113 to 119]

Organic EL elements 113 to 119 were prepared by the same way as the organic EL element 112 was prepared except that the exemplary compounds Ir-13, D-87, D-66, D-88, D-89, D-90 and D-91 were used as listed in Table 1, in place of the exemplary compound Ir-12 as the blue phosphorescence-emitting compounds used in the light-emitting layer.

[Preparation of Organic EL Element 120]

An organic EL element 120 was prepared by the same way as the organic EL element 114 was prepared except that the exemplary compound H-1 was used in place of the exemplary compound 1-31 as the host compound in the light-emitting layer.

[Preparation of Organic EL Element 121]

An organic EL element 121 was prepared by the same way as the organic EL element 120 was prepared except that the exemplary compound D-88 was used in place of the exemplary compound D-87 as the blue-phosphorescence-emitting compound in the light-emitting layer.

[Preparation of Organic EL Element 122]

An organic EL element 122 was prepared by the same way as the organic EL element 114 was prepared except that the exemplary compound 1-6 was used in place of the exemplary compound 1-7 as the host compound in the light-emitting layer.

[Preparation of Organic EL Element 123]

An organic EL element 123 was prepared by the same way as the organic EL element 122 was prepared except that the exemplary compound D-89 was used in place of the exemplary compound D-88 as the blue-phosphorescence-emitting compound in the light-emitting layer.

[Preparation of Organic EL Element 124]

An organic EL element 124 was prepared by the same way as the organic EL element 122 was prepared except that the exemplary compound 1-6 was used in place of the exemplary compound 1-7 as the host compound in the light-emitting layer.

[Preparation of Organic EL Element 125]

An organic EL element 125 was prepared by the same way as the organic EL element 124 was prepared except that the exemplary compound D-66 was used in place of the exemplary compound D-87 as the blue-phosphorescence-emitting compound in the light-emitting layer.

<<Evaluation of Organic EL Element>>

[Measurement of Power Efficiency]

A spectroradiometer CS-1000 (manufactured by Konica Minolta Sensing, Co., Ltd.) was used to measure front luminance and angle dependency of luminance of each of the organic EL elements, and power efficiency was obtained at a front luminance of 1000 cd/$m^2$ for each of the organic EL elements. In Table 1, relative values are shown defining the power efficiency of the organic EL element 104 as 100. A higher value represents more excellent power efficiency.

[Measurement of Half-Life Time]

Each of the organic EL element was driven with electrical current so as to give a front luminance of 5000 cd/$m^2$, and then the organic EL element was constantly driven. The time period until the front luminance decreased by a half (2500 cd/$m^2$) compared to the initial front luminance was obtained as a half-life time. In Table 1, relative values are shown defining the half-life time of the organic EL element 104 as 100. A higher value represents a more excellent life time (half-life time).

[Stability of Chromaticity Against Change in the driving condition, $\Delta E_1$]

Stability of chromaticity against change in the driving condition was obtained as follows. The maximum distance variation $\Delta E_1$ of the $x_1$ and $y_1$ values in CIE1931 within a front luminance of 300 to 1500 cd/$m^2$ was obtained according to the following equation. The obtained $\Delta E_1$ was evaluated according to the following criteria as stability of chromaticity

against change in the driving condition ($\Delta E_1$).

$$\Delta E_1 = (\Delta_{x1}{}^2 + \Delta_{y1}{}^2)^{1/2}$$

A: $\Delta E_1$ was less than 0.010
B: $\Delta E_1$ was 0.010 or more and less than 0.015
C: $\Delta E_1$ was 0.015 or more and less than 0.020
D: $\Delta E_1$ was 0.020 or more

[Stability of chromaticity After Continuous Driving, $\Delta E_2$]

Stability of chromaticity after continuous driving, $\Delta E_2$, was obtained as follows. Each of the organic EL element was driven with electrical current so as to give a front luminance of 5000 cd/m$^2$, and then the organic EL element was constantly driven until the front luminance decreased by a half (2500 cd/m$^2$) compared to the initial front luminance. The variation between the chromaticity at the finish of the driving and the chromaticity right after starting the driving was obtained as the maximum distance variation $\Delta E_2$ of the $x_2$ and $y_2$ values in CIE1931. The obtained results were classified into A to D.

$$\Delta E_2 = (\Delta_{x2}{}^2 + \Delta_{y2}{}^2)^{1/2}$$

A: $\Delta E_2$ was less than 0.010
B: $\Delta E_2$ was 0.010 or more and less than 0.015
C: $\Delta E_2$ was 0.015 or more and less than 0.020
D: $\Delta E_2$ was 0.020 or more

[Table 1]

| Sample No. | First light-emitting layer | | | | | | Second light-emitting layer | | | | | | Total thickness | Performance | | | | Note |
|---|---|---|---|---|---|---|---|---|---|---|---|---|---|---|---|---|---|---|
| | Host | | | Blue Dopant | | | Host | | | Blue Dopant | | | | | | | | |
| | Material | Ea (H) [eV] | $T_1$ (H) [eV] | Material | Ip (BD) [eV] | Thickness [nm] | Material | Ea (H) [eV] | $T_1$ (H) [eV] | Material | Ip (BD) [eV] | Thickness [nm] | | $\Delta E_1$ | $\Delta E_2$ | Power Efficiency [%] | Half-lite time [%] | |
| 101 | 1-6 | 2.15 | 2.79 | D-87 | 4.99 | 80 | - | - | - | - | - | - | 80 | D | D | 50 | 85 | Comparison |
| 102 | H-1 | 2.50 | 2.96 | D-87 | 4.99 | 80 | - | - | - | - | - | - | 80 | D | D | 90 | 45 | Comparison |
| 103 | 1-31 | 2.58 | 3.02 | D-87 | 4.99 | 80 | - | - | - | - | - | - | 80 | D | C | 70 | 40 | Comparison |
| 104 | 1-7 | 2.08 | 2.84 | D-87 | 4.99 | 80 | - | - | - | - | - | - | 80 | D | D | 100 | 100 | Comparison |
| 105 | 1-7 | 2.08 | 2.84 | D-66 | 5.04 | 80 | - | - | - | - | - | - | 80 | C | D | 85 | 105 | Comparison |
| 106 | 1-7 | 2.08 | 2.84 | D-88 | 5.23 | 80 | - | - | - | - | - | - | 80 | D | D | 95 | 90 | Comparison |
| 107 | 1-7 | 2.08 | 2.84 | D-90 | 5.10 | 80 | - | - | - | - | - | - | 80 | C | C | 90 | 90 | Comparison |
| 108 | 1-7 | 2.08 | 2.84 | D-91 | 5.17 | 80 | - | - | - | - | - | - | 80 | D | D | 90 | 95 | Comparison |
| 109 | 1-7 | 2.08 | 2.84 | D-89 | 4.82 | 80 | - | - | - | - | - | - | 80 | D | D | 100 | 90 | Comparison |
| 110 | 1-7 | 2.08 | 2.84 | Ir-12 | 6.40 | 80 | - | - | - | - | - | - | 80 | C | D | 60 | 50 | Comparison |
| 111 | 1-7 | 2.08 | 2.84 | Ir-13 | 6.16 | 80 | - | - | - | - | - | - | 80 | D | D | 50 | 40 | Comparison |
| 112 | 1-7 | 2.08 | 2.84 | Ir-12 | 6.40 | 40 | 1-31 | 2.58 | 3.02 | Ir-12 | 6.40 | 40 | 80 | C | C | 55 | 55 | Comparison |
| 113 | 1-7 | 2.08 | 2.84 | Ir-13 | 6.16 | 40 | 1-31 | 2.58 | 3.02 | Ir-13 | 6.16 | 40 | 80 | D | C | 55 | 50 | Comparison |
| 114 | 1-7 | 2.08 | 2.84 | D-87 | 4.99 | 40 | 1-31 | 2.58 | 3.02 | D-87 | 4.99 | 40 | 80 | A | A | 150 | 160 | Example |
| 115 | 1-7 | 2.08 | 2.84 | D-66 | 5.04 | 40 | 1-31 | 2.58 | 3.02 | D-66 | 5.04 | 40 | 80 | A | A | 145 | 155 | Example |
| 116 | 1-7 | 2.08 | 2.84 | D-88 | 5.23 | 40 | 1-31 | 2.58 | 3.02 | D-88 | 5.23 | 40 | 80 | B | A | 140 | 150 | Example |
| 117 | 1-7 | 2.08 | 2.84 | D-89 | 4.82 | 40 | 1-31 | 2.58 | 3.02 | D-89 | 4.82 | 40 | 80 | B | A | 140 | 160 | Example |
| 118 | 1-7 | 2.08 | 2.84 | D-90 | 5.10 | 40 | 1-31 | 2.58 | 3.02 | D-90 | 5.10 | 40 | 80 | A | A | 150 | 145 | Example |

(continued)

| Sample No. | First light-emitting layer | | | | | | Second light-emitting layer | | | | | | Total thickness | Performance | | | | Note |
|---|---|---|---|---|---|---|---|---|---|---|---|---|---|---|---|---|---|---|
| | Host | | | Blue Dopant | | | Host | | | Blue Dopant | | | | | | | | |
| | Material | Ea (H) [eV] | $T_1$ (H) [eV] | Material | Ip (BD) [eV] | Thickness [nm] | Material | Ea (H) [eV] | $T_1$ (H) [eV] | Material | Ip (BD) [eV] | Thickness [nm] | | $\Delta E_1$ | $\Delta E_2$ | Power Efficiency [%] | Half-lite time [%] | |
| 119 | 1-7 | 2.08 | 2.84 | D-91 | 5.17 | 40 | 1-31 | 2.58 | 3.02 | D-91 | 5.17 | 40 | 80 | A | B | 145 | 145 | Example |
| 120 | 1-7 | 2.08 | 2.84 | D-87 | 4.99 | 40 | H-1 | 2.50 | 2.96 | D-87 | 4.99 | 40 | 80 | A | B | 155 | 150 | Example |
| 121 | 1-7 | 2.08 | 2.84 | D-88 | 5.23 | 40 | H-1 | 2.50 | 2.96 | D-88 | 5.23 | 40 | 80 | A | A | 150 | 145 | Example |
| 122 | 1-6 | 2.15 | 2.79 | D-87 | 4.99 | 40 | 1-31 | 2.58 | 3.02 | D-87 | 4.99 | 40 | 80 | B | A | 140 | 160 | Example |
| 123 | 1-6 | 2.15 | 2.79 | D-89 | 4.82 | 40 | 1-31 | 2.58 | 3.02 | D-89 | 4.82 | 40 | 80 | A | A | 140 | 160 | Example |
| 124 | 1-6 | 2.15 | 2.79 | D-87 | 4.99 | 40 | H-1 | 2.50 | 2.96 | D-87 | 4.99 | 40 | 80 | B | A | 150 | 160 | Example |
| 125 | 1-6 | 2.15 | 2.79 | D-66 | 5.04 | 40 | H-1 | 2.50 | 2.96 | D-66 | 5.04 | 40 | 80 | A | A | 145 | 150 | Example |

As evident from results shown in Table 1, use of two light-emitting layers containing light-emitting host materials different from each other and use of blue phosphorescence-emitting dopants with less than 5.3 eV achieve improved power efficiencies and half-life times, and especially, achieve highly improved stabilities of chromaticity against change in the driving condition and after continuous driving.

Example 2

[Preparation of Organic EL Element 201]

An organic EL element 201 was prepared by the same way as the organic EL element 121 was prepared except that conditions for forming the light-emitting layer after forming the hole-transporting layer were changed as follows.

<Formation of First Light-Emitting Layer and Second Light-Emitting Layer>

The exemplary compound D-88 which is a blue phosphorescence-emitting compound, the exemplary compound Ir-1 which is a green phosphorescence-emitting compound, the exemplary compound Ir-14 which is a red phosphorescence-emitting compound and the exemplary compound 1-7 which is the host compound were co-deposited at a deposition rate of 0.1 nm/sec so as to form a 40 nm-thick first light-emitting layer containing 20% the exemplary compound D-88, 0.3% the exemplary compound Ir-1 and 0.3% the exemplary compound Ir-14 by weight. Thereafter, the exemplary compound D-88, the exemplary compound Ir-1, the exemplary compound Ir-14 and the exemplary compound H-1 which is the host compound were co-deposited at a deposition rate of 0.1 nm/sec so as to form a 40 nm-thick second light-emitting layer containing 20% the exemplary compound D-88, 0.3% the exemplary compound Ir-1 and 0.3% the exemplary compound Ir-14 by weight. The total thickness of this two-layered light-emitting layer prepared as described above was 80 nm.

[Preparation of Organic EL Element 202]

An organic EL element 202 was prepared by the same way as the above organic EL element 201 was prepared except that the host compound in the first light-emitting layer was the exemplary compound H-1 in place of the exemplary compound 1-7, and the host compound in the second light-emitting layer was the exemplary compound 1-7 in place of the exemplary compound H-1.

[Preparation of Organic EL Elements 203 to 207]

Organic EL elements 203 to 207 were prepared by the same way as the above organic EL element 201 was prepared except that the blue phosphorescence-emitting compounds (Blue Dopant) in the first light-emitting layer and the second light-emitting layer were the exemplary compounds D-87, D-66, D-89, D-90 and D-91 as listed in Table 2, in place of the exemplary compound D-88.

[Preparation of Organic EL Elements 208 to 211]

Organic EL elements 208 to 211 were prepared as the organic EL element 202 was prepared except that the light-emitting hosts used in the first light-emitting layer and the second light-emitting layer were changed as shown in Table 2 without changing deposition rates an thicknesses.

<<Evaluation of Organic EL Element>>

The prepared organic EL elements were evaluated for power efficiencies, half-life times and stabilities of chromaticity against change in the driving condition and after continuous driving by the same ways as described in Example 1. Values of power efficiencies and half-life times are relative values defining those of the organic EL element 104 as 100.

[Table 2]

| Sample No. | First light-emitting layer | | | | | | second light-emitting layer | | | | | | Total Thickness | Performance | | | | Note |
|---|---|---|---|---|---|---|---|---|---|---|---|---|---|---|---|---|---|---|
| | Host | | | Blue Dopant | | | Host | | | Blue Dopant | | | | | | | | |
| | Material | Ea (H) [eV] | $T_1$ (H) [eV] | Material | Ip (BD) [eV] | Thickness [nm] | Material | Ea (H) [eV] | $T_1$ (H) [ev] | Material | Ip (BD) [eV] | Thickness [nm] | | $\Delta E_1$ | $\Delta E_2$ | Power Efficiency [%] | Half-lite time [%] | |
| 301 | 1-6 | 2.15 | 2.79 | D-89 | 4.82 | 40 | 1-31 | 2.58 | 3.02 | D-89 | 4.82 | 40 | 80 | A | A | 140 | 160 | Example |
| 302 | H-3 | 2.17 | 2.84 | D-89 | 4.82 | 40 | 1-31 | 2.58 | 3.02 | D-89 | 4.82 | 40 | 80 | B | B | 130 | 110 | Example |
| 303 | H-2 | 1.74 | 2.82 | D-89 | 4.82 | 40 | 1-31 | 2.58 | 3.02 | D-89 | 4.82 | 40 | 80 | C | A | 130 | 115 | Example |
| 304 | H-3 | 2.17 | 2.84 | D-89 | 4.82 | 40 | H-1 | 2.50 | 2.96 | D-89 | 4.82 | 40 | 80 | C | B | 135 | 120 | Example |
| 305 | H-2 | 1.74 | 2.82 | D-89 | 4.82 | 40 | H-1 | 2.50 | 2.96 | D-89 | 4.82 | 40 | 80 | B | B | 130 | 110 | Example |
| 306 | H-2 | 1.74 | 2.82 | D-89 | 4.82 | 40 | H-3 | 2.17 | 2.84 | D-89 | 4.82 | 40 | 80 | B | B | 135 | 110 | Example |
| 307 | 1-7 | 2.08 | 2.84 | D-89 | 4.82 | 40 | H-3 | 2.17 | 2.84 | D-89 | 4.82 | 40 | 80 | B | C | 135 | 115 | Example |

As evident from results shown in Table 2, comparing electron affinities (Ea) of the light-emitting hosts and comparing triplet excitation energies ($T_1$) of the light-emitting hosts, the combinations where Ea of the light-emitting host in the first light-emitting layer is smaller than that of the light-emitting host in the second light-emitting layer, and the combinations where $T_1$ of the light-emitting host in the first light-emitting layer is smaller than that of the light-emitting host in the second light-emitting layer achieve improved performances including stabilities of chromaticity.

Example 3

[Preparation of Organic EL elements 301 to 307]

Organic EL elements 301 to 307 were prepared by the same way as the organic EL element 123 was prepared except that the light-emitting hosts used in the first light-emitting layer and the second light-emitting layer were changes as listed in Table 3 without changing deposition rates and thicknesses. The constitution of the organic EL element 301 was identical to that of the organic EL element 123.

<<Evaluation of Organic EL Element>>

The prepared organic EL elements were evaluated for power efficiencies, half-life times and stabilities of chromaticity against change in the driving condition and after continuous driving by the same ways as described in Example 1. Values of power efficiencies and half-life times are relative values defining those of the organic EL element 104 as 100.

[Table 3]

| Sample No. | First light-emitting layer | | | | | | Second light-emitting layer | | | | | | Total thick-ness | Performance | | | | Note |
|---|---|---|---|---|---|---|---|---|---|---|---|---|---|---|---|---|---|---|
| | Host | | | Blue Dopant | | | Host | | | Blue Dopant | | | | | | | | |
| | Material | Ea(H) [eV] | $T_1$(H) [eV] | Material | Ip (BD) [eV] | Thickness [nm] | Material | Ea (H) [eV] | $T_1$ (H) [eV] | Material | Ip (BD) [eV] | Thickness [nm] | | $\Delta E_1$ | $\Delta E_2$ | Power Efficiency [%] | Half-lite time [%] | |
| 201 | 1-7 | 2.08 | 2.84 | D-88 | 5.23 | 40 | H-1 | 2.50 | 2.96 | D-88 | 5.23 | 40 | 80 | A | A | 150 | 145 | Example |
| 202 | H-1 | 2.50 | 2.96 | D-88 | 5.23 | 40 | 1-7 | 2.08 | 2.84 | D-88 | 5.23 | 40 | 80 | B | C | 115 | 130 | Example |
| 203 | H-1 | 2.50 | 2.96 | D-87 | 4.99 | 40 | 1-7 | 2.08 | 2.84 | D-87 | 4.99 | 40 | 80 | B | B | 105 | 130 | Example |
| 204 | H-1 | 2.50 | 2.96 | D-66 | 5.04 | 40 | 1-7 | 2.08 | 2.84 | D-66 | 5.04 | 40 | 80 | B | B | 110 | 135 | Example |
| 205 | H-1 | 2.50 | 2.96 | D-89 | 4.82 | 40 | 1-7 | 2.08 | 2.84 | D-89 | 4.82 | 40 | 80 | B | B | 110 | 135 | Example |
| 206 | H-1 | 2.50 | 2.96 | D-90 | 5.10 | 40 | 1-7 | 2.08 | 2.84 | D-90 | 5.10 | 40 | 80 | C | B | 110 | 125 | Example |
| 207 | H-1 | 2.50 | 2.96 | D-91 | 5.17 | 40 | 1-7 | 2.08 | 2.84 | D-91 | 5.17 | 40 | 80 | B | B | 115 | 120 | Example |
| 208 | 1-6 | 2.15 | 2.79 | D-88 | 5.23 | 40 | 1-7 | 2.08 | 2.84 | D-88 | 5.23 | 40 | 80 | B | B | 120 | 120 | Example |
| 209 | 1-7 | 2.08 | 2.84 | D-88 | 5.23 | 40 | 1-6 | 2.15 | 2.79 | D-88 | 5.23 | 40 | 80 | B | C | 110 | 125 | Example |
| 210 | 1-31 | 2.58 | 3.02 | D-88 | 5.23 | 40 | 1-6 | 2.15 | 2.79 | D-88 | 5.23 | 40 | 80 | A | C | 125 | 135 | Example |
| 211 | 1-31 | 2.58 | 3.02 | D-88 | 5.23 | 40 | 1-7 | 2.08 | 2.84 | D-88 | 5.23 | 40 | 80 | B | B | 130 | 135 | Example |

As evident from results shown in Table 3, use of the light-emitting host including a carbazole group or carboline group achieves improved performances including stabilities of chromaticity.

Example 4

[Preparation of Organic EL Element 401 to 411]

Organic EL elements 401 to 411 were prepared by the same way as the organic EL element 114 was prepared except that the blue phosphorescence-emitting compounds used in the first light-emitting layer and the second light-emitting layer were changed to the combinations shown in Table 4 without changing deposition rates and thicknesses. The constitution of the organic EL element 401 was identical to that of the organic EL element 114.

<<Evaluation of Organic EL Element>>

The prepared organic EL elements were evaluated for power efficiencies, half-life times and stabilities of chromaticity against change in the driving condition and after continuous driving by the same ways as described in Example 1. Values of power efficiencies and half-life times are relative values defining those of the organic EL element 104 as 100.

[Table 4]

| Sample No. | First light-emitting layer | | | | | | Second light-emitting layer | | | | | | Total thickness | Performance | | | | Note |
|---|---|---|---|---|---|---|---|---|---|---|---|---|---|---|---|---|---|---|
| | Host | | | Blue Dopant | | | Host | | | Blue Dopant | | | | | | | | |
| | Material | Ea (H) [eV] | $T_1$ (H) [eV] | Material | Ip (BD) [eV] | Thickness [nm] | Material | Ea(H) [eV] | $T_1$ (H) [eV] | Material | Ip (BD) [eV] | Thickness [nm] | | $\Delta E_1$ | $\Delta E_2$ | Power Efficiency [%] | Halflite time [%] | |
| 401 | 1-7 | 2.08 | 2.84 | D-87 | 4.99 | 40 | 1-31 | 2.58 | 3.02 | D-87 | 4.99 | 40 | 80 | A | A | 150 | 160 | Example |
| 402 | 1-7 | 2.08 | 2.84 | D-87 | 4.99 | 40 | 1-31 | 2.58 | 3.02 | D-88 | 5.23 | 40 | 80 | B | B | 120 | 110 | Example |
| 403 | 1-7 | 2.08 | 2.84 | D-87 | 4.99 | 40 | 1-31 | 2.58 | 3.02 | D-89 | 4.82 | 40 | 80 | B | B | 120 | 120 | Example |
| 404 | 1-7 | 2.08 | 2.84 | D-87 | 4.99 | 40 | 1-31 | 2.58 | 3.02 | D-90 | 5.10 | 40 | 80 | B | C | 120 | 110 | Example |
| 405 | 1-7 | 2.08 | 2.84 | D-87 | 4.99 | 40 | 1-31 | 2.58 | 3.02 | D-91 | 5.17 | 40 | 80 | B | A | 115 | 110 | Example |
| 406 | 1-7 | 2.08 | 2.84 | D-87 | 4.99 | 40 | 1-31 | 2.58 | 3.02 | D-66 | 5.04 | 40 | 80 | B | B | 120 | 115 | Example |
| 407 | 1-7 | 2.08 | 2.84 | D-88 | 5.23 | 40 | 1-31 | 2.58 | 3.02 | D-87 | 4.99 | 40 | 80 | C | B | 115 | 120 | Example |
| 408 | 1-7 | 2.08 | 2.84 | D-89 | 4.82 | 40 | 1-31 | 2.58 | 3.02 | D-87 | 4.99 | 40 | 80 | B | B | 110 | 125 | Example |
| 409 | 1-7 | 2.08 | 2.84 | D-90 | 5.10 | 40 | 1-31 | 2.58 | 3.02 | D-87 | 4.99 | 40 | 80 | B | B | 115 | 125 | Example |
| 410 | 1-7 | 2.08 | 2.84 | D-91 | 5.17 | 40 | 1-31 | 2.58 | 3.02 | D-87 | 4.99 | 40 | 80 | B | C | 130 | 105 | Example |
| 411 | 1-7 | 2.08 | 2.84 | D-66 | 5.04 | 40 | 1-31 | 2.58 | 3.02 | D-87 | 4.99 | 40 | 80 | B | B | 120 | 120 | Example |

As evident from results shown in Table 4, the organic EL element 401 in which the blue phosphorescence-emitting compounds in the first light-emitting layer and the second light-emitting layer are the same especially achieves distinguishingly improved performances including stabilities of chromaticity compared to the other organic EL elements.

Example 5

[Preparation of Organic EL Elements 501 to 512]

Organic EL elements 501 to 512 were prepared by the same way as the organic EL element 125 was prepared except that the thicknesses of the first light-emitting layer and the second light-emitting layer were changed as shown in Table 5 without changing deposition rates. The constitution of the organic EL element 501 was identical to that of the organic EL element 125.

<<Evaluation of Organic EL Element>>

The prepared organic EL elements were evaluated for power efficiencies, half-life times and stabilities of chromaticity against change in the driving condition and after continuous driving by the same ways as described in Example 1. Values of power efficiencies and half-life times are relative values defining those of the organic EL element 104 as 100.

[Table 5]

| Sample No. | First light-emitting layer | | | | | | Second light-emitting layer | | | | | | Total thickness | Performance | | | | Note |
|---|---|---|---|---|---|---|---|---|---|---|---|---|---|---|---|---|---|---|
| | Host | | | Blue Dopant | | | Host | | | Blue Dopant | | | | | | | | |
| | Material | Ea(H) [eV] | $T_1$(H) [eV] | Material | Ip (BD) [eV] | Thickness [nm] | Material | Ea(H) [eV] | $T_1$(H) [eV] | Material | Ip (BD) [eV] | Thickness [nm] | | $\Delta E_1$ | $\Delta E_2$ | Power Efficiency [%] | Half-lite time [%] | |
| 501 | 1-6 | 2.15 | 2.79 | D-66 | 5.04 | 40 | H-1 | 2.50 | 2.96 | D-87 | 4.99 | 40 | 80 | A | A | 145 | 150 | Example |
| 502 | 1-6 | 2.15 | 2.79 | D-66 | 5.04 | 70 | H-1 | 2.50 | 3.02 | D-88 | 5.23 | 10 | 80 | A | A | 135 | 180 | Example |
| 503 | 1-6 | 2.15 | 2.79 | D-66 | 5.04 | 60 | H-1 | 2.50 | 3.02 | D-89 | 4.82 | 20 | 80 | A | A | 135 | 170 | Example |
| 504 | 1-6 | 2.15 | 2.79 | D-66 | 5.04 | 50 | H-1 | 2.50 | 3.02 | D-90 | 5.10 | 30 | 80 | A | A | 140 | 160 | Example |
| 505 | 1-6 | 2.15 | 2.79 | D-66 | 5.04 | 30 | H-1 | 2.50 | 3.02 | D-91 | 5.17 | 50 | 80 | B | A | 145 | 160 | Example |
| 506 | 1-6 | 2.15 | 2.79 | D-66 | 5.04 | 20 | H-1 | 2.50 | 3.02 | D-66 | 5.04 | 60 | 80 | B | A | 150 | 150 | Example |
| 507 | 1-6 | 2.15 | 2.79 | D-66 | 5.04 | 10 | H-1 | 2.50 | 3.02 | D-87 | 4.99 | 70 | 80 | B | B | 150 | 145 | Example |
| 508 | 1-6 | 2.15 | 2.79 | D-66 | 5.04 | 50 | H-1 | 2.50 | 3.02 | D-87 | 4.99 | 50 | 100 | A | A | 130 | 210 | Example |
| 509 | 1-6 | 2.15 | 2.79 | D-66 | 5.04 | 60 | H-1 | 2.50 | 3.02 | D-87 | 4.99 | 60 | 120 | A | A | 120 | 220 | Example |
| 510 | 1-6 | 2.15 | 2.79 | D-66 | 5.04 | 70 | H-1 | 2.50 | 3.02 | D-87 | 4.99 | 70 | 140 | B | B | 105 | 160 | Example |
| 511 | 1-6 | 2.15 | 2.79 | D-66 | 5.04 | 30 | H-1 | 2.50 | 3.02 | D-87 | 4.99 | 60 | 90 | A | A | 170 | 140 | Example |
| 512 | 1-6 | 2.15 | 2.79 | D-66 | 5.04 | 20 | H-1 | 2.50 | 3.02 | D-88 | 4.99 | 20 | 40 | B | B | 150 | 100 | Example |

As evident from results shown in Table 5, the organic EL elements where the total thickness of the first light-emitting layer and the second light-emitting layer is from 80 to 120 nm achieves distinguishingly improved performances including stabilities of chromaticity, regardless of the ratio of the thickness of the first light-emitting layer to the second light-emitting layer.

Industrial Applicability

The organic electroluminescence element of the present invention emitting phosphorescence of multiple colors shows high efficiencies in light emission and emission lifetime, and is suitably used for display devices, displays and various lighting devices.

Description of Reference Numerals

101 Organic EL element
102 Glass cover
105 Cathode
106 Organic EL layer
107 Glass substrate with transparent electrode
108 Nitrogen gas
109 Desiccant

## Claims

**1.** An organic electroluminescent element that emits white light by energization, comprising:

a pair of electrodes; and
two light-emitting layers provided between the electrodes, each of the light-emitting layers including a host material and a phosphorescence-emitting dopant, wherein
the host materials included in the respective light-emitting layers are different from each other,
at least one of the phosphorescence-emitting dopants included in the respective light-emitting layers is a blue phosphorescence-emitting dopant having an ionization potential (Ip) of 5.3 eV or less, and
at least one of the two light-emitting layers includes a plurality of the phosphorescence-emitting dopants.

**2.** The organic electroluminescent element of claim 1, wherein
an electron affinity (Ea) of the host material included in a second light-emitting layer is larger than an electron affinity of the host material included in a first light-emitting layer,
where a light emitting layer provided nearer to an anode is defined as the first light-emitting layer and another light-emitting layer is defined as the second light-emitting layer.

**3.** The organic electroluminescent element of claim 2, wherein
a lowest triplet excitation energy ($T_1$) of the host material included in the second light-emitting layer is higher than a lowest triplet excitation energy ($T_1$) of the host material included in the first light-emitting layer.

**4.** The organic electroluminescent element of any one of claims 1 to 3, wherein
the one or more phosphorescence-emitting dopants included in the two light-emitting layers are selected from compounds represented by the following general formulae (A), (B) and (C):

General formula (A)

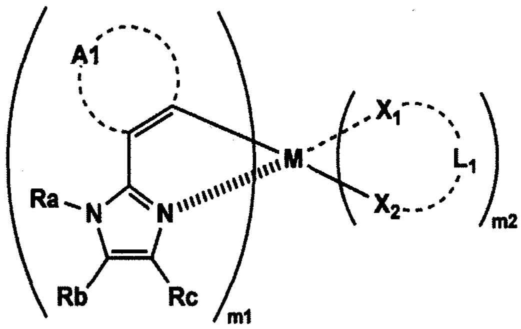

wherein in the formula, Ra represents a hydrogen atom, an aliphatic group, an aromatic group or a hetero ring; Rb and Rc each represent a hydrogen atom or a substituent; A1 represents a residue necessary for forming an aromatic ring or an aromatic hetero ring; M represents Ir or Pt; $X_1$ and $X_2$ each represent a carbon atom, a nitrogen atom or an oxygen atom; $L_1$ represents a group of atoms forming a bidentate ligand together with $X_1$ and $X_2$; m1 represents an integer 1, 2 or 3; m2 represents an integer 0, 1 or 2; and m1+m2 is 2 or 3;

General formula (B)

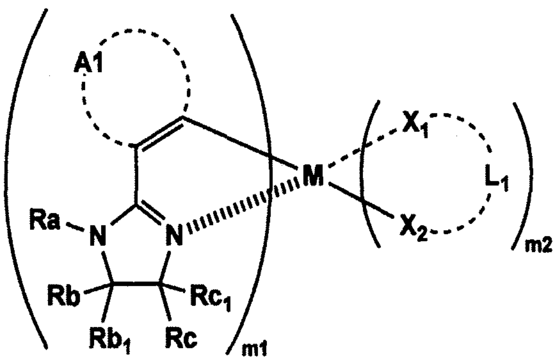

wherein in the formula, Ra represents a hydrogen atom, an aliphatic group, an aromatic group or a hetero ring; Rb, Rc, $Rb_1$ and $Rc_1$ each represent a hydrogen atom or a substituent; A1 represents a residue necessary for forming an aromatic ring or an aromatic hetero ring; M represents Ir or Pt; $X_1$ and $X_2$ each represent a carbon atom, a nitrogen atom or an oxygen atom; $L_1$ represents a group of atoms forming a bidentate ligand together with $X_1$ and $X_2$; m1 represents an integer 1, 2 or 3; m2 represents an integer 0, 1 oar 2; and m1+m2 is 2 or 3; and

General formula (C)

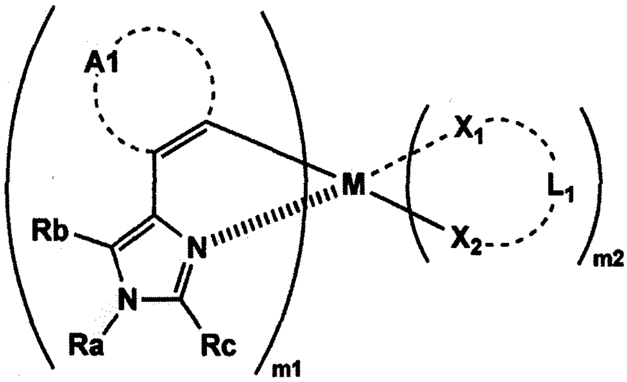

wherein in the formula, Ra represents a hydrogen atom, an aliphatic group, an aromatic group or a hetero ring; Rb and Rc each represent a hydrogen atom or a substituent; A1 represents a residue necessary for forming an aromatic ring or an aromatic hetero ring; M represents Ir or Pt; $X_1$ and $X_2$ each represent a carbon atom, a nitrogen atom or an oxygen atom; $L_1$ represents a group of atoms forming a bidentate ligand together with $X_1$ and $X_2$; m1 represents an integer 1, 2 or 3; m2 represents an integer 0, 1 or 2; and m1+m2 is 2 or 3.

**5.** The organic electroluminescent element of any one of claims 2 to 4, wherein the host compound included in the first light-emitting layer and the host compound included in the second light-emitting layer include a carbazole group or carboline group.

**6.** The organic electroluminescent element of any one of claims 2 to 5, wherein the first light-emitting layer and the second light-emitting layer include a same blue phosphorescence-emitting dopant.

**7.** The organic electroluminescent element of any one of claims 2 to 6, wherein a total thickness of the first light-emitting layer and the second light-emitting layer ranges from 60 to 120 nm.

**8.** The organic electroluminescent element of any one of claims 2 to 7, wherein the first light-emitting layer and the second light-emitting layer comprise (1) the dopant having a maximum emission wavelength of less than 480 nm, (2) the dopant having a maximum emission wavelength ranging from 500 nm or more to less than 580 nm, and (3) the dopant having a maximum emission wavelength of 580 nm or more, in a light emission spectrum, respectively.

**9.** A lighting device comprising the organic electroluminescent element of any one of claims 1 to 8.

# FIG.1

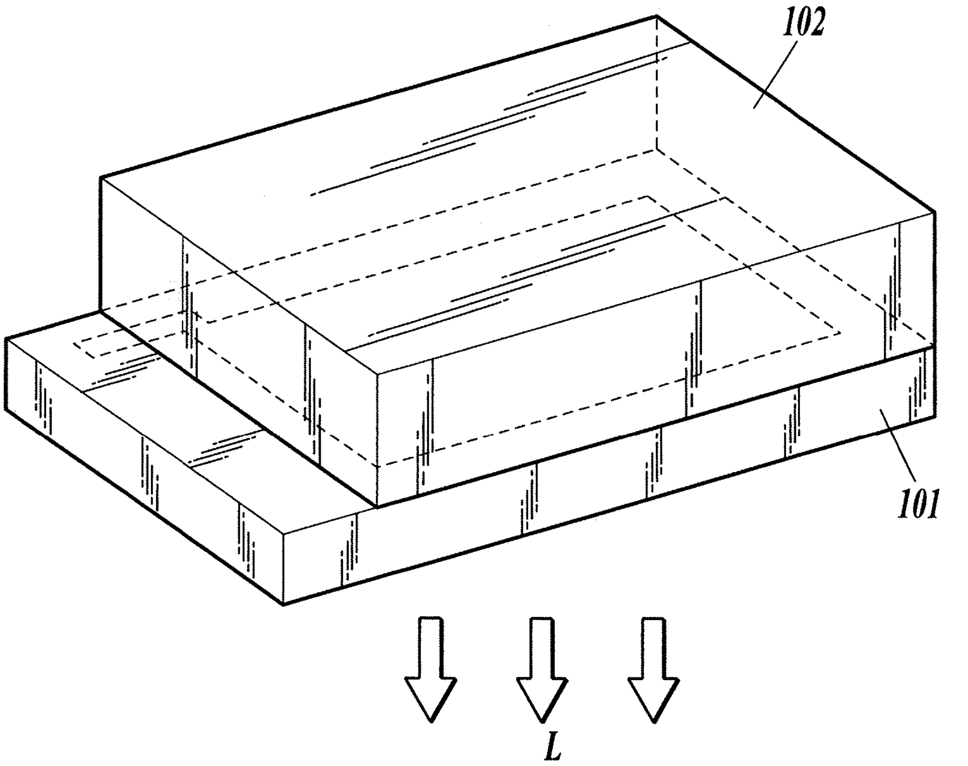


# FIG.2

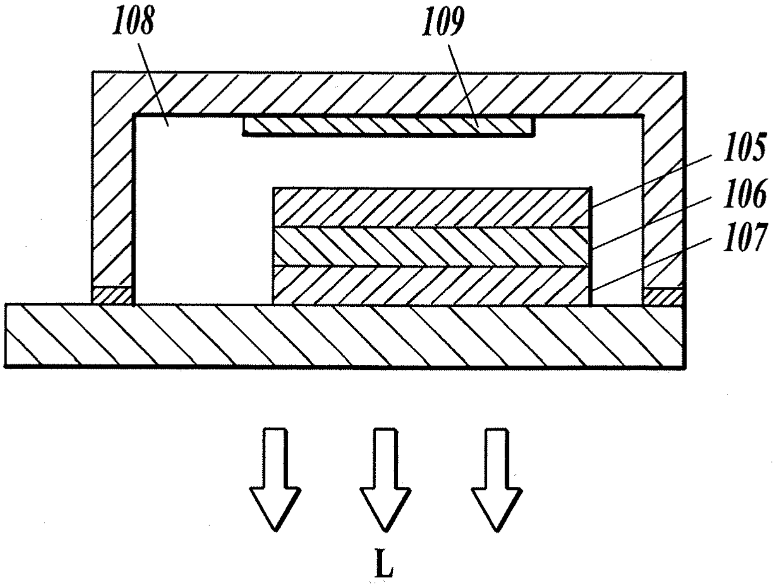

**INTERNATIONAL SEARCH REPORT**

International application No.
PCT/JP2012/058116

A. CLASSIFICATION OF SUBJECT MATTER
*H01L51/50*(2006.01)i, *C09K11/06*(2006.01)i, *H05B33/12*(2006.01)i, *F21Y105/00*(2006.01)n

According to International Patent Classification (IPC) or to both national classification and IPC

B. FIELDS SEARCHED

Minimum documentation searched (classification system followed by classification symbols)
H01L51/50, C09K11/06, H05B33/12, F21Y105/00

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 2007-250716 A (Konica Minolta Holdings, Inc.), 27 September 2007 (27.09.2007), paragraph [0155] (Family: none) | 1,4,9 |
| X<br>Y | JP 2008-84913 A (Konica Minolta Holdings, Inc.), 10 April 2008 (10.04.2008), paragraphs [0112], [0115], [0117], [0229] (Family: none) | 1-6,9<br>7,8 |
| Y | WO 2005/091684 A1 (Idemitsu Kosan Co., Ltd.), 29 September 2005 (29.09.2005), paragraph [0108] & US 2007/0194701 A1 & EP 1727396 A1 & KR 10-2006-0129478 A & CN 1934906 A | 7 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 25 May, 2012 (25.05.12) | 05 June, 2012 (05.06.12) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.
PCT/JP2012/058116

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2010-161356 A (Fujifilm Corp.), 22 July 2010 (22.07.2010), paragraph [0017] & US 2010/0140605 A1 | 8 |
| A | WO 2005/079118 A1 (Idemitsu Kosan Co., Ltd.), 25 August 2005 (25.08.2005), paragraph [0058] & US 2007/0159083 A1 & EP 1718122 A1 & KR 10-2006-0114009 A & CN 1918946 A | 2,3 |
| A | WO 2008/035595 A1 (Konica Minolta Holdings, Inc.), 27 March 2008 (27.03.2008), paragraph [0045] (Family: none) | 1-9 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP HEI6207170 B
- JP 2004235168 A
- WO 2004077886 A
- US 6097147 A
- JP 2010034484 A
- JP 2008084913 A
- JP 2001257076 A
- JP 2002308855 A
- JP 2001313179 A
- JP 2002319491 A
- JP 2001357977 A
- JP 2002334786 A
- JP 2002008860 A
- JP 2002334787 A
- JP 2002015871 A
- JP 2002334788 A
- JP 2002043056 A
- JP 2002334789 A
- JP 2002075645 A
- JP 2002338579 A
- JP 2002105445 A
- JP 2002343568 A
- JP 2002141173 A
- JP 2002352957 A
- JP 2002203683 A
- JP 2002363227 A
- JP 2002231453 A
- JP 2003003165 A
- JP 2002234888 A
- JP 2003027048 A
- JP 2002255934 A
- JP 2002260861 A
- JP 2002280183 A
- JP 2002299060 A
- JP 2002302516 A
- JP 2002305083 A
- JP 2002305084 A
- JP 2002308837 A
- JP HEI945479 B
- JP HEI9260062 B
- JP HEI8288069 B
- JP 2003519432 A
- JP HEI6325871 B
- JP HEI917574 B
- JP HEI1074586 B
- JP HEI11204258 B
- JP HEI11204359 B
- US 5061569 A
- JP HEI4308688 B
- JP HEI4297076 B
- JP 2000196140 A
- JP 2001102175 A
- JP HEI11251067 B
- JP HEI10270172 B
- JP 2004068143 A
- US 4774435 A
- JP SHO63314795 B
- JP HEI1220394 B
- JP SHO62172691 B
- JP 2001202827 A
- JP HEI11283751 B
- JP 2001269105 A
- JP 2001286373 A
- JP 2003288995 A
- JP 2004321074 A
- JP 2004354232 A
- JP 2004358063 A
- JP 2005322602 A


### Non-patent literature cited in the description


- **M. A. BALDO et al.** *Nature,* 1998, vol. 395, 151-154
- **M. A. BALDO et al.** *Nature,* 2000, vol. 403 (17), 750-753
- Handbook of Color Science. University of Tokyo Press, 1985, 108
- Experimental Chemistry 7, Spectroscopy II. MARUZEN Co., Ltd, 1992, 398
- *Inorg. Chem.,* vol. 40, 1704-1711
- Organic EL element and its frontier of industrialization. Electrode Materials. NTS Corporation, 30 November 1998, 123-166
- The frontier of Organic EL element and its industrialization. NTS Inc, 30 November 1998, 237
- *J. Appl. Phys.,* 2004, vol. 95, 5773
- **J. HUANG et al.** *Applied Physics Letters,* 2002, vol. 80, 139